(19) Europäisches Patentamt
European Patent Office
Office européen des brevets

(11) **EP 4 654 787 A1**

(12) **EUROPEAN PATENT APPLICATION**
published in accordance with Art. 153(4) EPC

(43) Date of publication:
**26.11.2025 Bulletin 2025/48**

(21) Application number: **25753388.5**

(22) Date of filing: **19.03.2025**

(51) International Patent Classification (IPC):
*H10F 19/00* (2025.01)

(52) Cooperative Patent Classification (CPC):
**H10F 19/00; H10F 77/30; H10F 77/50**

(86) International application number:
**PCT/CN2025/083383**

(87) International publication number:
**WO 2025/201131 (02.10.2025 Gazette 2025/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: 29.03.2024 CN 202410383010
29.03.2024 CN 202420644308 U
29.03.2024 CN 202420645705 U
29.03.2024 CN 202420645462 U
29.03.2024 CN 202420644202 U
29.05.2024 CN 202421203803 U
08.02.2025 CN 202520208673 U
08.02.2025 CN 202520201131 U
25.02.2025 CN 202510215009
26.02.2025 CN 202510221271
21.02.2025 CN 202510198949

(71) Applicant: **LONGi Green Energy Technology Co., Ltd.**
**Xi'an, Shaanxi 710100 (CN)**

(72) Inventors:
• **CHEN, Cheng**
Xi'an, Shaanxi 710100 (CN)
• **ZHANG, Gang**
Xi'an, Shaanxi 710100 (CN)
• **GUO, Menglong**
Xi'an, Shaanxi 710100 (CN)
• **TONG, Hongbo**
Xi'an, Shaanxi 710100 (CN)
• **YU, Long**
Xi'an, Shaanxi 710100 (CN)
• **DENG, Shengjie**
Xi'an, Shaanxi 710100 (CN)
• **JIN, Yupeng**
Xi'an, Shaanxi 710100 (CN)

(74) Representative: **Pfenning, Meinig & Partner mbB**
**Patent- und Rechtsanwälte**
**Theresienhöhe 11a**
**80339 München (DE)**

(54) **SOLAR CELL, CELL STACK STRUCTURE, AND PHOTOVOLTAIC MODULE**

(57)   The present application discloses a solar cell, a solar cell stacked structure, and a photovoltaic module. The solar cell includes a solar cell body, and an isolation member is provided on at least one surface of the solar cell body. Further, in a solar cell stacking process, the isolation member is used to form isolation protection on a surface of a solar cell, to avoid scratch on the surface of the solar cell.

FIG. 1

**Description**

**CROSS-REFERENCE TO RELATED APPLICATIONS**

The present application claims priority to Chinese Patent Application No. 202410383010.1, filed with the China National Intellectual Property Administration on March 29, 2024, and entitled "SOLAR CELL AND PHOTOVOLTAIC MODULE", to Chinese Patent Application No. 202420645705.8, filed with the China National Intellectual Property Administration on March 29, 2024, and entitled "SOLAR CELL AND PHOTOVOLTAIC MODULE", to Chinese Patent Application No. 202420644308.9, filed with the China National Intellectual Property Administration on March 29, 2024, and entitled "SOLAR CELL, STACKED STRUCTURE, AND SOLAR CELL MODULE", to Chinese Patent Application No. 202420645462.8, filed with the China National Intellectual Property Administration on March 29, 2024, and entitled "SOLAR CELL STACKED STRUCTURE AND FIXTURE CONTAINING SOLAR CELL STACKED STRUCTURE", to Chinese Patent Application No. 202420644202.9, filed with the China National Intellectual Property Administration on March 29, 2024, and entitled "SOLAR CELL AND PHOTOVOLTAIC MODULE", to Chinese Patent Application No. 202421203803.2, filed with the China National Intellectual Property Administration on May 29, 2024, and entitled "SOLAR CELL AND PHOTOVOLTAIC MODULE", to Chinese Patent Application No. 202510198949.5, filed with the China National Intellectual Property Administration on February 21, 2025, and entitled "SOLAR CELL AND PHOTOVOLTAIC MODULE", to Chinese Patent Application No. 202520201131.X, filed with the China National Intellectual Property Administration on February 8, 2025, and entitled "SOLAR CELL AND PHOTOVOLTAIC MODULE", to Chinese Patent Application No. 202520208673.X, filed with the China National Intellectual Property Administration on February 8, 2025, and entitled "SOLAR CELL MODULE", to Chinese Patent Application No. 202510215009.2, filed with the China National Intellectual Property Administration on February 25, 2025, and entitled "SOLAR CELL AND PHOTOVOLTAIC MODULE", and to Chinese Patent Application No. 202510221271.8, filed with the China National Intellectual Property Administration on February 26, 2025, and entitled "SOLAR CELL AND PHOTOVOLTAIC MODULE", which are incorporated herein by reference in their entireties.

**TECHNICAL FIELD**

The present application belongs to the field of photovoltaic technologies, and specifically, to a solar cell, a solar cell stacked structure, and a photovoltaic module.

**BACKGROUND**

In a back contact solar cell, both a PN junction and a metal electrode are disposed on a back surface of the solar cell, to prevent the electrode from blocking a light receiving surface of the solar cell, so that incident light can be maximally used, and optical losses can be reduced, thereby improving conversion efficiency of the solar cell.

In a production and manufacturing process of a back contact solar cell, solar cells usually need to be stacked and transferred. In a related technology, to avoid scuffing between the solar cells, a release paper/coated paper is usually used for blocking between two adjacent solar cells. However, in the manner of isolation by using the release paper/coated paper, the release paper/coated paper further needs to be extracted before laminating, an operation process is complex, and the release paper/coated paper has high costs and is prone to offset. Debris falling off the release paper easily attach to a surface of the solar cell, affecting quality of a laminate.

**SUMMARY**

The present application aims to provide a solar cell, a solar cell stacked structure, and a photovoltaic module, to resolve a problem that when solar cells are stacked and transferred, scuffing between the solar cells causes surfaces of the solar cells to be scratched.

To resolve the foregoing technical problem, the present application is implemented as follows:

According to a first aspect, the present application provides a solar cell, including: a solar cell body, and an isolation member is disposed on at least one surface of the solar cell body. In the present application, in a solar cell stacking process, the isolation member is used to form isolation protection on a surface of the solar cell, to avoid scratch on the surface of the solar cell.

In an embodiment, the isolation member includes a plurality of isolation bumps arranged at intervals, a refractive index of the plurality of isolation bumps being less than a refractive index of the solar cell body.

In an embodiment, the solar cell body has a light receiving surface and a back surface opposite to the light receiving surface, the plurality of isolation bumps being disposed on the light receiving surface.

In an embodiment, a plurality of pyramid structures are disposed on a surface of the solar cell body on which the plurality of isolation bumps are provided, the plurality of isolation bumps covering at least two of the plurality of pyramid structures; and/or the plurality of the isolation bumps are arranged in an array; and/or a material of the plurality of isolation bumps is a UV adhesive; and/or a Mohs hardness of the plurality of isolation bumps ranges from 2 to 7.

In an embodiment, a respective isolation member of the isolation members includes a recess recessing into the respective isolation member from a surface of the respective isolation member facing away from the solar cell body; and/or a coverage ratio of the plurality of isolation members on the surface of the solar cell is S81, satisfying: $0.5\% \leq S81 \leq 10\%$; and/or a height of the plurality of isolation members in a thickness direction of the solar cell is h, satisfying $2\,\mu m \leq h \leq 80\,\mu m$.

In an embodiment, the plurality of isolation members include a first protective structure and a second protective structure; at least one surface of the solar cell body includes a middle region and an edge region surrounding the middle region; the edge region is provided with the first protective structure, the middle region is provided with the second protective structure, and the first protective structure is arranged surrounding the second protective structure; and a coverage ratio of the first protective structure on the edge region is greater than a coverage ratio of the second protective structure on the middle region.

In an embodiment, the isolation member includes an isolation film arranged on the light receiving surface of the solar cell body, the isolation film being provided with a hollow structure.

In an embodiment, the solar cell body has a light receiving surface and a back surface, the back surface is provided with electrodes, and the light receiving surface is provided with the plurality of isolation members arranged at intervals, an extension direction of at least some of the isolation members being intersected with an extension direction of the electrodes.

In an embodiment, the solar cell body has a first surface and a second surface opposite to the first surface; the solar cell further includes a plurality of fingers disposed on the first surface of the solar cell body; a plurality of isolation members are disposed on the first surface and/or the second surface of the solar cell body, an extension direction of the plurality of isolation members being intersected with an extension direction of the plurality of fingers; the isolation members include a plurality of isolation bumps arranged along the extension direction of the isolation members; and a distance between two adjacent isolation bumps in a same isolation member in the extension direction of the plurality of isolation members is greater than a distance between two adjacent fingers.

In an embodiment, a plurality of isolation members arranged at intervals are disposed on at least one surface of the solar cell body, the isolation members including a central portion and a peripheral portion disposed around the central portion; and a surface of the central portion away from the solar cell body includes a recess, and in a direction perpendicular to the solar cell body, a minimum height of the central portion is H71, and a maximum height of the plurality of isolation members is H70, satisfying: $0 < H71 \leq \dfrac{2}{3}H70$.

In an embodiment, the solar cell body includes a light receiving surface and a back surface opposite to the light receiving surface, the light receiving surface including a fifth region and a plurality of sixth regions; a plurality of isolation members are disposed on the light receiving surface of the solar cell body, a density of a part of the plurality of isolation members in the fifth region being greater than a density of a part of the plurality of isolation members in the sixth region; and the solar cell further includes a plurality of fingers disposed on the back surface of the solar cell body, the plurality of sixth regions being defined along an extension direction of the plurality of fingers, an extension direction of the plurality of sixth regions being perpendicular to the plurality of fingers.

In an embodiment, the solar cell body includes a first surface and a second surface opposite to the first surface; and the isolation member includes a plurality of isolation bumps disposed on at least one of the first surface and the second surface of the solar cell body, the plurality of isolation bumps being arranged in a plurality of rows along a fourth direction, and each of the plurality of rows of the isolation bumps include a plurality of isolation bumps arranged along a fifth direction; where *l* is a larger one of a distance between two adjacent isolation bumps along the fourth direction or a distance between two adjacent isolation bumps along the fifth direction, h is a height of the plurality of isolation bumps, n is rounding of a ratio of a long side to a short side of the solar cell, and *l*, h, and n satisfy the following relationship:

$$0 < l < \sqrt[4]{15.3 * 10^5 mm^3 * hn}.$$

According to a second aspect, the present application provides a photovoltaic module, including the solar cell according to the foregoing descriptions.

In an embodiment, the photovoltaic module further includes a cover, a back sheet, and a packaging adhesive film; the solar cell is packaged between the cover and the back sheet by the packaging adhesive film; and a peeling strength between the isolation member and the solar cell is greater than a peeling strength between the isolation member and the packaging adhesive film.

According to a third aspect, the present application provides a solar cell stacked structure, including a plurality of the solar cells according to the foregoing descriptions that are sequentially stacked and that include electrodes, and the electrodes are disposed on the back surface of the solar cell body.

In an embodiment, at least a part of the solar cell stacked structure includes a plurality of groups of solar cells; and each of the plurality of groups of solar cells includes two solar cells whose back surfaces are in contact with each other; and for two adjacent solar cells whose light receiving surfaces are in contact with each other in the solar cell stacked structure, a protective adhesive layer is provided on the light receiving surface of at least one of the solar cells, the protective adhesive layer being used as the isolation member.

Additional aspects and advantages of the present application will be given in the following descriptions, some of which will become apparent from the following descriptions or may be learned from practices of the present application.

## BRIEF DESCRIPTION OF THE DRAWINGS

The foregoing and/or additional aspects and advantages of the present application become apparent and comprehensible in the descriptions made with reference to the following accompanying drawings, where:

FIG. 1 is a schematic diagram of a solar cell according to a first group of embodiments of the present application;
FIG. 2 is a schematic diagram of a photovoltaic module according to the first group of embodiments of the present application;
FIG. 3a is a schematic diagram of a processing procedure of a solar cell according to the first group of embodiments of the present application;
FIG. 3b is a schematic diagram of another processing procedure of a solar cell according to the first group of embodiments of the present application;
FIG. 4 is a schematic diagram of a first solar cell according to a second group of embodiments of the present application;
FIG. 5 is a cross-sectional view of a solar cell according to the second group of embodiments of the present application;
FIG. 6 is a schematic diagram of a solar cell according to the second group of embodiments of the present application;
FIG. 7 is a schematic structural diagram of a top view of a solar cell according to a third group of embodiments of the present application;
FIG. 8 is a schematic structural diagram of a cross section of a solar cell stacked structure according to an embodiment of the present application;
FIG. 9 is a schematic diagram of a solar cell according to a fourth group of embodiments of the present application;
FIG. 10 is a schematic diagram of another solar cell according to the fourth group of embodiments of the present application;
FIG. 11 is a schematic structural diagram of an arrangement of isolation members and fingers of a solar cell according to a fifth group of embodiments of the present application;
FIG. 12 is a schematic structural diagram of another arrangement of isolation members and fingers of a solar cell according to the fifth group of embodiments of the present application;
FIG. 13 is a schematic structural diagram of an arrangement of fingers of a solar cell according to the fifth group of embodiments of the present application;
FIG. 14 is a top view of an arrangement of isolation members of a solar cell according to a sixth group of embodiments of the present application;
FIG. 15 is a schematic structural diagram of a cross section of the isolation member in FIG. 14;
FIG. 16 is a schematic structural diagram of the isolation member in FIG. 14;
FIG. 17 is a schematic structural diagram of a photovoltaic module according to the sixth group of embodiments of the present application;
FIG. 18 is a schematic structural diagram of a top view of a solar cell according to a seventh group of embodiments of the present application;
FIG. 19 is a schematic structural diagram of a top view of a solar cell according to the seventh group of embodiments of the present application;
FIG. 20 is a schematic structural diagram of a top view of a solar cell according to the seventh group of embodiments of the present application;
FIG. 21 is a schematic structural diagram of a top view of a solar cell according to the seventh group of embodiments of the present application;
FIG. 22 is a schematic diagram of a solar cell during a test according to the seventh group of embodiments of the present application;
FIG. 23 is a schematic structural diagram of a first arrangement manner of an isolation bump in a solar cell according to an eighth group of embodiments of the present application;
FIG. 24 is a schematic structural diagram of a second arrangement manner of an isolation bump in a solar cell according to the eighth group of embodiments of the present application; and

FIG. 25 is a schematic diagram of a solar cell bending under a force when stacked according to the eighth group of embodiments of the present application.

Reference numerals:

100: Solar cell; 100a: solar cell body; 110: electrode; 101: light receiving surface; 102: back surface; 420: pyramid structure; 230: isolation bump; 501: curved surface; 140: adhesive film layer; 110a: middle region; 110b: edge region; 103: side; H5: height of the isolation bump along a direction perpendicular to a first surface; L1: size of the isolation bump at an interface between the first surface and a second surface; H6: height of the adhesive film layer; H51: height of the isolation bump;

510: first protective structure 520: hollow structure; 511: first protrusion; 530: second protective structure; 513: third protrusion; H3: height of the first protective structure; H4: height of the second protective structure; D: distance from a boundary of the edge region close to the middle region to the corresponding side;

540: isolation film; 300: protective adhesive layer;

W: each group of solar cell;

102a: first region; 102b: second region; 102c: third region; 102d: fourth region; 120: isolation member; 121: first isolation member; 122: second isolation member; X: first direction; Y: second direction;

621: isolation bump; 63: finger; 631: first finger; 6311: first sub-finger; 632: second finger; 6321: second sub-finger; L61: distance between two adjacent isolation bumps in a same isolation member in a direction S2; L62: distance between two adjacent fingers; L63: distance between two adjacent isolation bumps in a same isolation member in a direction S3 perpendicular to the finger; L64: distance between two adjacent first fingers; L65: distance between two adjacent second fingers;

711: peripheral portion; 7113: cavity; 712: central portion; 7121: recess; 7124: cover layer; 730: packaging adhesive film; 51: cover; 52: back sheet; H71: minimum height of the central portion; H70: maximum height of the isolation member; W70: maximum size of an orthogonal projection of the isolation member on the solar cell body; W71: maximum size of an orthogonal projection of the central portion on the solar cell body;

813: fifth region; 8131: third sub-region; 814: sixth region; 8141: first sub-region; 8142: second sub-region; 840: pad; 850: testing mechanism; 851: pressing member; 852: testing probe; 860: first end line; 861: second end line; X8: extension direction of the sixth region is along the finger;

911: first side; 912: second side; X9: fourth direction; Y9: fifth direction; L92: distance between two adjacent isolation bumps along the fourth direction; L91: distance between two adjacent isolation bumps along the fifth direction; and h: height of the isolation bump.

## DETAILED DESCRIPTION

The following describes embodiments of the present application in detail. Examples of the embodiments are shown in the accompanying drawings, and same or similar reference signs in all the accompanying drawings indicate same or similar components or components having same or similar functions. The embodiments described below with reference to the accompanying drawings are exemplary, and are merely intended to explain the disclosure and cannot be construed as a limitation to the present disclosure. All other embodiments obtained by a person of ordinary skill in the art based on the embodiments of the present application without creative efforts shall fall within the protection scope of the present application.

A feature defined by the term "first" or "second" in the specification and the claims of the present application may explicitly or implicitly include one or more features. In the descriptions of the present application, unless otherwise stated, "a plurality of" means two or more than two. In addition, in this specification and the claims "and/or" generally indicates at least one of connected objects, and the character "/" generally indicates an "or" relationship between associated objects.

In the descriptions of the present application, it should be understood that orientation or position relationships indicated by the terms such as "center", "longitudinal", "transverse", "length", "width", "thickness", "on", "below", "front", "back", "left", "right", "vertical", "horizontal", "top", "bottom", "inside", "outside", "clockwise", "anticlockwise", "axial direction", "radial direction", and "circumferential direction" are based on orientation or position relationships shown in the accompanying drawings, and are used only for ease and brevity of illustration and description, rather than indicating or implying that the mentioned apparatus or component must have a particular orientation or must be constructed and operated in a particular orientation. Therefore, such terms should not be construed as limiting of the present application.

In the descriptions of the present application, it should be noted that unless otherwise explicitly specified or defined, the terms such as "mount", "install", "connect", and "connection" should be understood in a broad sense. For example, the connection may be a fixed connection, a detachable connection, or an integral connection; or the connection may be a mechanical connection or an electrical connection; or the connection may be a direct connection, an indirect connection through an intermediary, or internal communication between two components. A person of ordinary skill in the art may understand the specific meanings of the foregoing terms in the present application according to specific situations.

The solar cell and the photovoltaic module provided in the embodiments of the present application are described in detail below with reference to the accompanying drawings by using specific embodiments and application scenarios thereof.

According to a first aspect, the present application provides a solar cell, including: a solar cell body, where an isolation member is provided on at least one side of the solar cell body.

The solar cell in the first aspect of the embodiments of the present application is described in detail in the following.

The solar cell (also referred to as a cell for short) includes a solar cell body. The solar cell body has a light receiving surface and a back surface. The light receiving surface is a side of the solar cell that receives incident light. The back surface is a side of the solar cell that faces away from the light receiving surface. The back surface is disposed opposite to the light receiving surface. A front face of the solar cell body is the light receiving surface, and a back face of the solar cell body is the back surface.

An example in which the solar cell is a back contact solar cell is used below for description. When the solar cell is a solar cell of another type, for a function mechanism of the solar cell, refer to the execution herein. Details are not described herein again in the embodiments of the present application.

For example, the solar cell in the embodiments of the present application is a back contact solar cell, and electrodes of the back contact solar cell are all disposed on the back surface. The electrodes include positive electrodes and negative electrodes. The light receiving surface of the back contact solar cell may be completely exposed to sunlight, thereby improving light absorbing efficiency. The design of the back contact solar cell can also reduce current transmission paths, lower resistance, and improve performance of the solar cell. During transport of the back contact solar cell, a plurality of back contact solar cells need to be stacked. In this case, a film layer on a light receiving surface of a solar cell is easily scuffed by grid lines on a back surface of an adjacent solar cell. When a plurality of solar cells are stacked in a solar cell transport process in the embodiments of the present application, because of disposition of isolation members, there is no need to dispose a release paper between two adjacent solar cells, so as to avoid technical problems of increasing production processes and affecting production capacity because the release paper is placed on the solar cell and is removed during subsequent production at a component end. In addition, a technical problem that discarding of the release paper causes large costs and wastes is avoided.

In an embodiment, a plurality of isolation members arranged at intervals may be disposed on at least one of the light receiving surface and the back surface of the solar cell body. For example, a plurality of isolation members may be disposed on the light receiving surface of the solar cell body. For another example, the isolation members may alternatively be disposed on the back surface of the solar cell body, or may be disposed on both the light receiving surface and the back surface. Descriptions are provided below mainly by using an example in which the isolation members are disposed on the light receiving surface of the solar cell body. When the isolation member is disposed on the back surface, a principle thereof is the same as or similar to the principle herein, and details are not described herein again.

In an embodiment, a manner in which the isolation members are arranged on the back surface of the solar cell body is not specifically limited in the embodiments of the present application. For example, the isolation members are printed on the surface of the solar cell body. For another example, the isolation members are disposed on the surface of the solar cell body in an ink-jet manner. For another example, the isolation members are disposed on the surface of the solar cell body in a dispensing manner. For another example, the isolation members are pasted to the surface of the solar cell body. For another example, the isolation members are plated on the surface of the solar cell body.

In an embodiment, a plurality of isolation members arranged at intervals are disposed on the light receiving surface of the solar cell body, and a plurality of electrodes are disposed on the back surface of the solar cell body, and the plurality of electrodes are arranged at intervals.

In an embodiment, in an implementation, the isolation member is a planar adhesive layer completely covering the light receiving surface of the solar cell. In this way, a protection area of the isolation member for the light receiving surface of the solar cell can be improved, so as to completely avoid scratch damage on the light receiving surface of the solar cell, thereby having a good protection effect.

In an embodiment, in another implementation, the solar cell includes a plurality of isolation members disposed at intervals; and the isolation members include any one of an adhesive dot, an adhesive strip, or an adhesive block.

In the embodiments of the present application, to further reduce an amount of adhesive and reduce production costs, the protective adhesive layer may be set to include a plurality of isolation members disposed at intervals. The isolation members include any one of an adhesive dot, an adhesive strip, or an adhesive block. In this way, the planar adhesive layer does not need to completely cover the light receiving surface of the solar cell, thereby reducing the amount of used adhesive.

Adhesive dot-type isolation members, adhesive strip-type isolation members, and adhesive block-type isolation members may all be distributed on the light receiving surface of the solar cell in an array. Regardless of which form of the protective adhesive unit is used, effective support, isolation, and cushion can be formed on the light receiving surface of the solar cell, thereby producing an effective protection function on the light receiving surface of the solar cell.

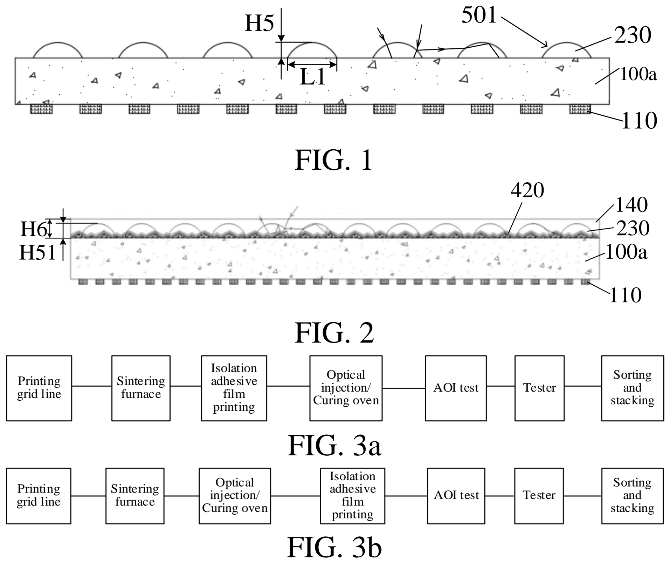

A structure of a solar cell in the first group of embodiments in the first aspect of the present application is described in detail in the following with reference to FIG. 1 to FIG. 3b.

In this group of embodiments, isolation members include several isolation bumps 230 arranged at intervals. As shown in FIG. 1, the solar cell according to some embodiments of the present application includes a solar cell body 100a, where at least one side of the solar cell body 100a is provided with a plurality of isolation bumps 230 arranged at intervals.

In some examples, a refractive index of the isolation bumps 230 is less than a refractive index of the solar cell body 100a.

For example, the solar cell in the embodiments of the present application is a back contact solar cell, electrodes 121 of the back contact solar cell are all disposed on a back surface, and a plurality of isolation bumps 500 arranged at intervals may be disposed on a light receiving surface of the back contact solar cell. An example in which the solar cell is a back contact solar cell is used below for description. When the solar cell is a solar cell of another type, for a function mechanism of the solar cell, refer to the execution herein. Details are not described herein again in the embodiments of the present application.

It may be understood that, in a solar cell preparation process, a plurality of solar cells are usually stored or transferred by using boxes. When a plurality of solar cells are stacked, in two solar cells stacked up and down, a light receiving surface of one solar cell may face a back surface of the other solar cell, so that the light receiving surface of the one solar cell is easily scuffed by electrodes 110 on the back surface of the other solar cell.

Therefore, in the embodiments of the present application, a plurality of isolation bumps 230 arranged at intervals are disposed on the light receiving surface of the solar cell, so that in a stacking process, an isolation supporting function can be formed between two adjacent solar cells by using the isolation bumps 230, to form isolation protection on the light receiving surface of the solar cell, thereby preventing the light receiving surface of the solar cell from being scuffed by the electrodes 110 on the back surface of the adjacent solar cell.

In addition, by setting the refractive index of the isolation bumps 230 to be less than the refractive index of the solar cell body 100a, as shown by an arrow in FIG. 1, when incident light is irradiated on the isolation bumps 230, most light is transmitted through the isolation bumps 230 and is absorbed by the solar cell, and a small part of light is repeatedly refracted or reflected between a plurality of isolation bumps 230 and is absorbed by the solar cell again, thereby forming a light trapping effect, increasing a light absorbing rate of the solar cell, and improving conversion efficiency of the solar cell.

In some embodiments, the isolation bumps 230 are made of a transparent material, for example, may be made of a transparent material such as a UV adhesive, a photo-sensitive adhesive, a polyolefin elastomer (POE), or an ethylene vinyl acetate copolymer (EVA). In an embodiment, a main component of the UV adhesive is an acrylic resin.

A light transmittance of the isolation bumps 230 may be set to be greater than or equal to 80%. For example, the light transmittance of the isolation bumps 230 is set to any value such as 80%, 83%, 85%, 87%, 90%, 93%, 95%, or 98% or a range between any two values. In some examples, the light transmittance of the isolation bumps 230 is greater than or equal to 85%.

In some embodiments, the isolation bumps 230 include, but are not limited to, a strip-shaped bump, a dotted bump, and the like. The strip-shaped bump may be a bump structure continuously extending along a preset direction, or may be a strip-shaped structure formed by a plurality of dotted bumps sequentially arranged along a same direction. Certainly, a structure of another shape may also be used for the isolation bumps 230. This is not limited in the embodiments of the present application.

In some embodiments, a Mohs hardness of the isolation bumps 230 ranges from 2 to 7. For example, the Mohs Hardness of the isolation bumps 230 may be set to any value such as 2, 3, 4, 5, 6, or 7, or a range between any two values.

It may be understood that, a passivation layer, for example, a silicon nitride layer is usually formed on the surface of the solar cell body 100a. A Mohs Hardness of the silicon nitride layer ranges from 9 to 9.5. Therefore, the Mohs Hardness of the isolation bumps 230 is set to 2 to 7, so that the Mohs hardness of the isolation bumps 230 is lower than the Mohs hardness of the passivation layer on the surface of the solar cell body 100a. Further, when the solar cells are stacked, the isolation bumps 230 can provide a supporting and isolation function, and moreover, scratch on the surface of the solar cell body 100a is prevented from being caused by the isolation bumps 230.

In an embodiment, a plurality of isolation bumps 230 are arranged in an array on the surface of the solar cell, to increase distribution uniformity of the isolation bumps 230 on the surface of the solar cell body 100a, thereby improving a protection function for different areas on the surface of the solar cell, and forming a uniform light trapping effect at different positions on the surface of the solar cell.

In an embodiment, a ratio of the refractive index of the isolation bumps 230 to the refractive index of the solar cell body 100a ranges from 0.6 to 1.15. In some examples, a ratio of the refractive index of the isolation bump 230 to the refractive index of the solar cell body 100a ranges from 0.8 to 0.95.

In the embodiments of the present application, the refractive index of the isolation bump 230 is set to be less than the refractive index of the solar cell body 100a, and the ratio range of the refractive index of the isolation bump 230 to the refractive index of the solar cell body 100a is set, to ensure that the light trapping effect can be formed on the surface of the solar cell body 100a, so that the isolation and protecting effect can be formed on the surface of the solar cell by using the isolation bumps 230, and the light absorbing rate of the solar cell can be further improved, thereby improving the conversion efficiency of the solar cell.

For example, the ratio of the refractive index of the isolation bump 230 to the refractive index of the solar cell body 100a may be set to any value such as 0.6, 0.7, 0.8, 0.82, 0.85, 0.87, 0.9, 0.93, 0.95, 1, or 1.15, or a range between any two values.

In an embodiment, the refractive index of the isolation bumps 230 ranges from 1.4 to 1.9. In some examples, the refractive index of the isolation bumps 230 ranges from: 1.6 to 1.7.

In the embodiments of the present application, by setting the refractive index range of the isolation bumps 230, when the plurality of isolation bumps 230 on the surface of the solar cell are used to perform isolation protection on the solar cell, the plurality of isolation bumps 230 can further be used to form the light trapping effect on the surface of the solar cell 100, thereby increasing the light absorption of the solar cell and improving the conversion efficiency of the solar cell.

For example, the refractive index of the isolation bumps 230 may be set to any value such as 1.4, 1.5, 1.6, 1.61, 1.63, 1.65, 1.68, 1.7, 1.8, or 1.9, or a range between any two values.

In an embodiment, the refractive index of the solar cell body 100a ranges from 1.6 to 2.2. In some examples, the refractive index of the solar cell body 100a ranges from 1.8 to 2.

In the embodiments of the present application, by setting the refractive index range of the solar cell body 100a, it is ensured that the refractive index of the solar cell body 100a is greater than the refractive index of the isolation bumps 230, so that the plurality of isolation bumps 230 on the surface of the solar cell body 100a can form the light trapping effect, thereby increasing the light absorption rate of the solar cell, and improving the conversion efficiency of the solar cell.

For example, the refractive index of the solar cell body 100a may be set to any value such as 1.6, 1.7, 1.8, 1.82, 1.85, 1.87, 1.9, 1.93, 1.95, 1.98, 2.0, 2.1, or 2.2, or a range between any two of the values.

In an embodiment, as shown in FIG. 1, a surface of the isolation bump 230 facing away from the solar cell body 100a is a curved surface 501. The curved surface 501 protrudes from the surface of the solar cell body 100a to a direction away from the solar cell body 100a.

In the embodiments of the present application, the surface of the side of the isolation bump 230 facing away from the solar cell body 100a is set to the curved surface 501. This facilitates actual design and processing, and also facilitates forming the light trapping effect on the surface of the solar cell body 100a, thereby improving the light absorption rate of the solar cell, and improving the conversion efficiency of the solar cell.

For example, the curved surface 501 formed by the surface of the isolation bump 230 facing away from the solar cell body 100a may be a curved structure such as an arc surface, an ellipsoidal surface, or a parabolic curved surface. Certainly, the curved surface may alternatively be set to a curved surface structure of another shape. The curved surface structure may be set flexibly according to an actual situation. This is not limited in the embodiments of the present application.

In an embodiment, a curvature of the curved surface 501 is greater than or equal to 0.05 $\mu$m-1.

In the embodiments of the present application, the curvature of the curved surface 501 formed by the surface of the isolation bump 230 facing away from the solar cell body 100a is controlled, to ensure that the surface of the isolation bump 230 facing away from the solar cell body 100a has a curvature, thereby facilitating forming the light trapping effect. In addition, it can also be ensured that the isolation bump 230 has a certain height, to achieve a function of isolation and protecting the surface of the solar cell body 100a.

For example, the curvature of the curved surface 501 may be set to any value such as 0.05 $\mu$m-1, 0.08 $\mu$m-1, 0.1 $\mu$m-1, 0.5 $\mu$m-1, 1.0 $\mu$m-1, 2.0 $\mu$m-1, or 5. 0 $\mu$m-1, or a range between any two values.

In an embodiment, as shown in FIG. 1, a surface of the solar cell body 100a provided with the isolation bumps 230 is a first surface, a height of the isolation bumps 230 along a direction perpendicular to the first surface is H5, a cross section perpendicular to a direction in which the isolation bumps 230 are arranged is a second cross section, and a size of the isolation bumps 230 at an interface between the first surface and the second cross section is L1 (referred to as a width L1 for short), that is, a maximum size L1 of a projection of the isolation bumps 230 on the solar cell body 100a satisfies: HS/L1 $\geq$ 0.001. In an embodiment, 0.1 $\leq$ H5/L1 $\leq$ 0.5.

In the embodiments of the present application, by setting a proper ratio of the height to the width of the isolation bumps 230, the isolation and protection effect of the isolation bumps 230 on the surface of the solar cell can be ensured, and a good light trapping effect can be formed on the surface of the solar cell, helping improve the photoelectric conversion efficiency of the solar cell.

It may be understood that, if the ratio of the height to the width of the isolation bumps 230 is excessively small, in other words, the height of the isolation bumps 230 is small and the width of the isolation bumps 230 is large, the isolation supporting function of the isolation bumps 230 and the light absorption rate of the solar cell are affected, and a corresponding topography of an excessively small ratio of the height to the width of the isolation bumps 230 may weaken the light trapping effect formed on the surface of the solar cell. However, if the ratio of the height to the width of the isolation bump 230 is excessively large, in other words, the height of the isolation bumps 230 is large and the width of the isolation bumps 230 is small, structural strength of the isolation bumps 230 is reduced. This is inconvenient for actual processing, and the isolation bumps 230 are easily broken, affecting use stability of the isolation bumps 230.

For example, a ratio H5/L1 of the height H5 of the isolation bumps 230 to the width L1 of the isolation bumps 230 may be set to any value such as 0.001, 0.05, 0.1, 0.15, 0.2, 0.25, 0.3, 0.4, 0.5, 0.6, or 0.7, or a range between any two values.

It should be noted that, the distribution direction of the isolation bumps is an extension direction of a projection of the isolation bumps on the first surface. For example, a distribution direction of strip-shaped isolation bumps is a length direction of strip-shaped projections on the first surface. For another example, a distribution direction of semispherical isolation bumps is a radius direction of a projection of the semispherical shape on the first surface. For another example, a distribution direction of semi-ellipsoidal isolation bumps is a short radius direction or a long radius direction of a projection of the semi-ellipsoidal shape on the first surface.

In an embodiment, as shown in FIG. 1, the height H5 of the isolation bumps 230 along the direction perpendicular to the first surface is 2 $\mu$m to 80 $\mu$m. In some examples, the height H5 of the isolation bumps 230 along the direction perpendicular to the first surface is 5 $\mu$m to 40 $\mu$m.

In the embodiments of the present application, when H5 < 2 $\mu$m, the height H5 of the isolation bumps 230 is excessively small. Therefore, when adjacent solar cells are stacked, the isolation bumps 230 cannot effectively block fingers, busbars, end lines, pads, and the like on an adjacent solar cell from being in contact with the light receiving surface 101 of the other solar cell. Consequently, the anti-scratch effect may not be achieved, or the anti-scratch effect is poor. When H5 > 80 $\mu$m, processing difficulty of the isolation bumps 230 is high and material costs are high. By setting a range of the height H5 of the isolation bumps 230 along the direction perpendicular to the first surface, it can be ensured that the isolation bumps 230 have a particular height. When the solar cells are stacked, the isolation bumps 230 can perform an isolation and supporting function between two adjacent solar cells, to prevent scuffing. In addition, by setting the isolation bumps 230 to have a certain height can ensure that an effective light trapping effect can be formed on the surface of the solar cell body 100a, to improve the conversion efficiency of the solar cell and reduce processing difficulty and material costs.

For example, the height H5 of the isolation bumps 230 along the direction perpendicular to the first surface may be set to any value such as 2 $\mu$m, 4 $\mu$m, 5 $\mu$m, 8 $\mu$m, 10 $\mu$m, 15 $\mu$m, 20 $\mu$m, 25 $\mu$m, 30 $\mu$m, 35 $\mu$m, 40 $\mu$m, 65 $\mu$m, or 80 $\mu$m, or a range between any two values.

It should be noted that, a measurement manner of the height H5 of the isolation bumps 230 includes: along the direction perpendicular to the first surface, measuring a linear distance from any point on the surface of the isolation bumps 230 to the first surface, and using a maximum value as a measurement value of the height H5 of the isolation bumps 230.

In an embodiment, as shown in FIG. 1, the size L1 of the isolation bumps 230 at the interface between the first surface and the second cross section is 0.05 mm to 2 mm. In some examples, the size L1 of the isolation bumps 230 at the interface between the first surface and the second cross section is 100 $\mu$m to 300 $\mu$m.

In the embodiments of the present application, the range of the size L1 of the isolation bumps 230 at the interface between the first surface and the second cross section is set, so that the isolation bumps 230 form a particular coverage area on the surface of the solar cell, thereby protecting the surface of the solar cell. In addition, if the width of the isolation bumps 230 is excessively large, the ratio of the height to the width of the isolation bumps 230 is small, and the corresponding topography may weaken a light trapping effect formed on the surface of the solar cell body 100a.

For example, the size L1 of the isolation bumps 230 at the interface between the first surface and the second cross section may be set to any value such as 0.05 mm, 0.1 mm, 0.5 mm, 1.05 mm, 1.55 mm, or 2 mm, or a range between any two values.

In some embodiments, the height of the isolation bumps 230 is directly proportional to a distance between two adjacent isolation bumps 230. For example, the distance between two adjacent isolation bumps 230 is 10 mm to 12 mm, and correspondingly, the height of the isolation bumps 230 is set to 30 $\mu$m. Alternatively, the distance between two adjacent isolation bumps 230 is 3 mm to 5 mm, and correspondingly, the height of the isolation bumps 230 is set to 10 $\mu$m.

In an embodiment, as shown in FIG. 2, a plurality of pyramid structures 420 are disposed on a surface of the solar cell body 100a on which the isolation bumps 230 are disposed, and the isolation bumps 230 cover at least two pyramid structures 420.

In the embodiments of the present application, the plurality of pyramid structures 420 are disposed on the surface of the side of the solar cell body 100a on which the isolation bumps 230 are disposed, so that the isolation bumps 230 cover at least two pyramid structures 420. In this way, by using a cooperative effect of the plurality of isolation bumps 230 and the plurality of pyramid structures 420, the light trapping effect formed on the surface of the solar cell body 100a can be enhanced, thereby further improving the conversion efficiency of the solar cell.

It may be understood that, in a solar cell preparation process, a textured structure may be formed on the light receiving surface and/or the back surface of a silicon substrate by using a texturing process, to further form an anti-reflection layer or a passivation layer on the textured structure, and form the solar cell body 100a whose surface is formed with the plurality of pyramid structures 420. Further, a plurality of isolation bumps 230 are processed on the anti-reflection layer or the passivation layer, and the isolation bumps 230 cover at least two pyramid structures 420.

In some embodiments, as shown in FIG. 3a, the solar cell preparation process in the present application may include the following steps:

S1: Provide a solar cell body 100a, where the solar cell body 100a includes a light receiving surface and a back surface opposite to the light receiving surface.
S2: Print electrodes on the back surface of the solar cell body 100a, and perform sintering in a sintering furnace.
S3: Form isolation bumps 230 on the light receiving surface of the solar cell body 100a.
S4: Process the solar cell body 100a by using optical injection or a curing oven.
S5: Perform performance detection on solar cells, and sort and stack the solar cells.

It may be understood that, in a conventional solar cell production process, after the performance detection on the solar cells is completed, the solar cells need to be separated by using release papers, and need to be sorted and stacked. Procedures such as release paper installation and extraction need to be added in the operation process. Consequently, the operation process is complex and production costs are high.

In the embodiments of the present application, after printing of electrode pastes and high-temperature sintering are completed, the isolation bumps 230 are formed on the light receiving surface of the solar cell, so that in the subsequent process, the isolation bumps 230 can be used to achieve a function of isolation and protecting the solar cell, thereby simplifying the operation process and reducing the production costs.

In some other embodiments, as shown in FIG. 3b, after the sintering operation in the sintering furnace is completed in step S2, the solar cell body 100a may be first processed by using optical injection or a curing oven, and then the isolation bumps 230 are formed on the light receiving surface of the solar cell body 100a. In this way, a requirement on high temperature resistance of the isolation bumps 230 can be reduced.

In some embodiments, step S3 of forming the isolation bumps 230 on the light receiving surface of the solar cell body 100a in the foregoing embodiment may include the following steps:

S31: Form a plurality of preset adhesive dots on the light receiving surface of the solar cell body 100a by using a preset adhesive material.
S32: Cure the preset adhesive dots to obtain a plurality of isolation bumps 230 arranged at intervals, where a refractive index of the isolation bumps 230 is less than a refractive index of the solar cell body 100a.

Specifically, the isolation bumps 230 may be printed on the surface of the solar cell body 100a in a manner of screen printing.

Certainly, the plurality of preset adhesive dots may alternatively be formed on the light receiving surface of the solar cell body 100a in a manner such as dispensing or coating. The plurality of preset adhesive dots may be flexibly set according to an actual situation. This is not limited in the embodiments of the present application.

In some other embodiments, a viscosity of the used preset adhesive material is set to 7000 cps to 20000 cps. High-temperature resistance of the formed isolation bumps 230 is greater than or equal to 300°C.

It should be noted that, for solar cell preparation processes in the following embodiments, refer to the solar cell preparation process in this embodiment.

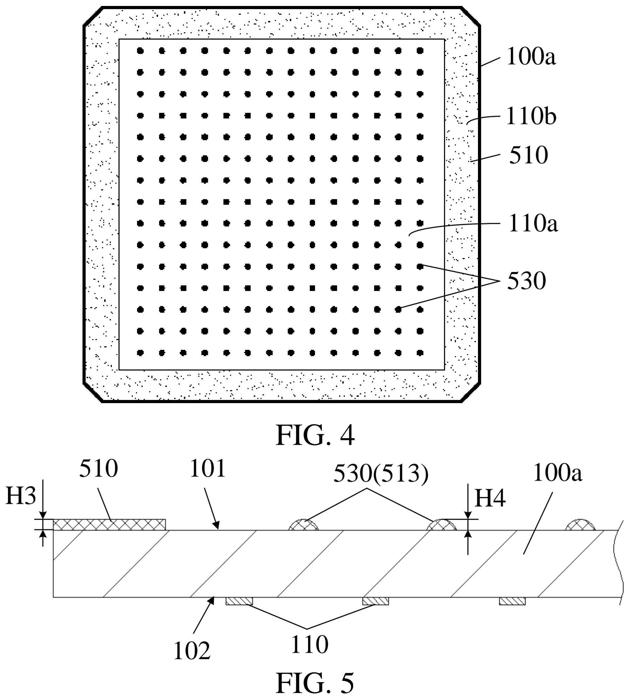

A structure of a solar cell in the second group of embodiments in the first aspect of the present application is described in detail in the following with reference to FIG. 4 to FIG. 6.

The isolation member includes a first protective structure 510 and a second protective structure 530. As shown in FIG. 4 and FIG. 5, a solar cell according to some embodiments of the present application includes: a solar cell body 100a. At least one surface of the solar cell body 100a has a middle region 110a and an edge region 110b surrounding the middle region 110a. The edge region 110b is provided with a first protective structure 510, the middle region 110a is provided with a second protective structure 530, and the first protective structure 510 is disposed around the second protective structure 530.

In the embodiments of the present application, the protective structures are respectively disposed in the middle region 110a and the edge region 110b on at least one surface of the solar cell body 100a, to achieve a function of isolation and protecting the surface of the solar cell during stacking and transport processes of the solar cell, thereby avoiding scratch on the surface of the solar cell. In addition, the protective structure disposed on the edge region 110b of the surface of the solar cell body 100a has a structure different from that of the middle region 110a, to differentially protect different regions on the surface of the solar cell body 100a, thereby satisfying different protection requirements. In addition, the first protective structure 510 and the second protective structure 530 are disposed to be combined with the solar cell body 100a, so that during a subsequent layering operation, the protective structure does not need to be specially removed, thereby simplifying the laminating process, and reducing production costs.

In some examples, as shown in FIG. 5, the first protective structure 510 and the second protective structure 530 may be disposed on the light receiving surface 101 of the solar cell. Alternatively, the first protective structure 510 and the second protective structure 530 are disposed on the back surface 102 of the solar cell. Alternatively, the first protective structure 510 and the second protective structure 530 are disposed on both the light receiving surface 101 and the back surface 102 of the solar cell.

For example, the solar cell in the embodiments of the present application is a back contact solar cell. The electrodes 110 of the back contact solar cell are all disposed on the back surface 102. Further, the first protective structure 510 and the second protective structure 530 are respectively disposed on the light receiving surface 101 of the solar cell. It should be noted that, in the following embodiment, an example in which the solar cell is a back contact solar cell, and the first protective structure 510 and the second protective structure 530 are disposed on the light receiving surface 101 of the solar cell is used for description. When the solar cell is of another structure, refer to the execution herein. Details are not described herein again in the embodiments of the present application.

It may be understood that, in a production and manufacturing process of a photovoltaic module, generally, a plurality of solar cells need to be sequentially stacked into a box for storage or transport. In this part of embodiments in the present disclosure, an example in which a plurality of solar cells are stored into a box with the light receiving surface 101 facing upward, and electrode 110 of the solar cells are disposed on the back surface 102 is used for description. When the solar cells are stacked in another manner, refer to the execution herein. Details are not described herein again.

During actual application, when a plurality of solar cells are stacked, if electrodes 110 on a back surface 102 of an upper solar cell is directly in contact with a light receiving surface 101 of a lower solar cell, it easily causes friction and scratch on the light receiving surface 101 of the lower solar cell. In addition, it is found through research that, during a process of placing the solar cells into the box, when the solar cells fall, the solar cells usually tend to be inclined and misplaced, and an edge of an upper solar cell easily cracks a peripheral edge region 110b of a lower solar cell, thereby increasing a risk that the peripheral edge region 110b of the lower solar cell is scuffed or bumped.

In view of this, in the embodiments of the present application, the protective structures are disposed on both the middle region 110a and the edge region 110b of the light receiving surface 101 of the solar cell, to form omni-directional isolation protection for the light receiving surface 101 of the solar cell. In addition, the edge region 110b and the middle region 110a of the light receiving surface 101 are differentially protected by using different protective structures, to satisfy different protection requirements, so as to strengthen protection on the peripheral edge region 110b of the light receiving surface 101.

It should be noted that, the edge region in the present application refers to a region on a surface of a solar cell body close to a peripheral edge of the solar cell, and the middle region refers to a region on a surface of a solar cell body close to a middle position of the solar cell. Compared with the edge region, the middle region is closer to a geometric center of the solar cell body.

In some embodiments, for materials of the first protective structure 510 and the second protective structure 530, refer to the material of the isolation bumps 230 in the first group of embodiments in the first aspect, and details are not described herein again.

Materials for preparing the first protective structure 510 and the second protective structure 530 may be the same, or may be different. This is not limited in the embodiments of the present application.

In an embodiment, a coverage ratio of the first protective structure 510 on the edge region 110b is greater than a coverage ratio of the second protective structure 530 on the middle region 110a.

In the embodiments of the present application, a relationship between the coverage ratios on regions in which the first protective structure 510 and the second protective structure 530 are located is set, to enhance a protective effect on the peripheral edge region 110b of the light receiving surface 101 while satisfying an isolation and protection effect on the light receiving surface 101.

The coverage ratio of the first protective structure 510 on the edge region 110b is a ratio of an area of an orthogonal projection of the first protective structure 510 on the light receiving surface 101 to an area of the edge region 110b of the light receiving surface 101. The coverage ratio of the second protective structure 530 on the middle region 110a is a ratio of an area of an orthogonal projection of the second protective structure 530 on the light receiving surface 101 to an area of the middle region 110a of the light receiving surface 101.

It may be understood that, structural shapes of the first protective structure 510 and the second protective structure 530 may be the same, or may be different. This is not limited in the embodiments of the present application. When the structural shapes of the first protective structure 510 and the second protective structure 530 are set to be the same, distribution density of the first protective structure 510 and the second protective structure 530 in corresponding regions may be set to be different, to differentially protect different regions of the light receiving surface 101.

In an embodiment, as shown in FIG. 4, the first protective structure 510 includes a transparent material layer, and the transparent material layer covers the edge region 110b.

In the embodiments of the present application, the peripheral edge region 110b of the light receiving surface 101 is set to be covered by the transparent material layer, to strengthen the isolation and protection function on the peripheral edge region 110b, thereby reducing a risk that the peripheral edge region 110b of the light receiving surface 101 is scuffed or bumped.

In an embodiment, the transparent material layer is provided with a plurality of hollow structures disposed at intervals. While ensuring coverage protection of the transparent material layer on the edge region 110b of the light receiving surface 101, light shielding of the transparent material layer on the light receiving surface can be reduced, and a quantity of raw materials for preparing the transparent material layer can be reduced, thereby reducing production costs.

The hollow structure may be a hole or a slot disposed in the transparent material layer.

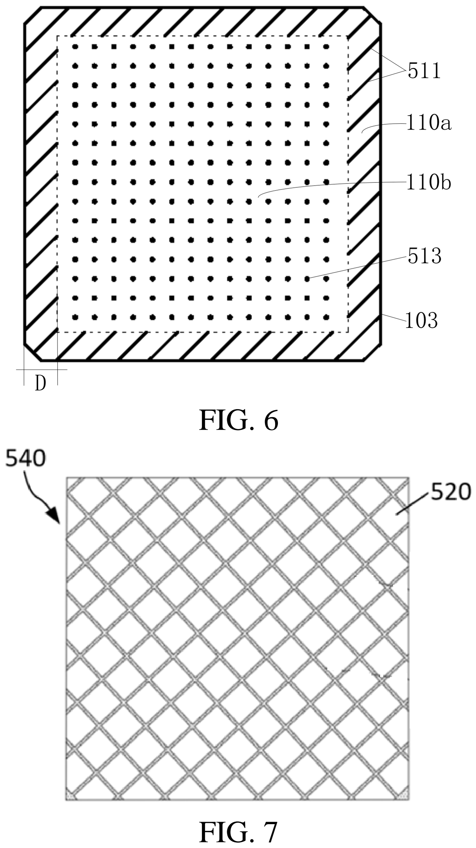

In an embodiment, as shown in FIG. 6, the first protective structure 510 includes first protrusions 511. The solar cell body 100a has four sides 103, a plurality of first protrusions 511 are disposed in an edge region 110b corresponding to each side 103, and the first protrusion 511 extends from the side 103 toward the middle region 110a.

In the embodiments of the present application, the first protrusions 511 extend from the side 103 of the solar cell toward the middle region 110a, that is, the first protrusions 511 are in a strip-shaped structure. Using the first protrusions 511 of the strip-shaped structure can achieve a function of isolation and protecting the peripheral edge region 110b of the light receiving surface 101, and can also save the quantity of raw materials for production and reduce production costs.

In an embodiment, the first protective structure 510 further includes a plurality of second projections, and each second projection is connected to at least one first projection 511 to form a network structure.

In the embodiments of the present application, each second protrusion is connected to at least one first protrusion 511, and then a plurality of second projections are connected to a plurality of first projections 511 to form a network structure. This can improve the isolation and protecting function on the peripheral edge region 110b of the light receiving surface 101 of the solar cell, and can also improve overall structural strength of the first protective structure 510, and improve a service life of the first protective structure 510.

In an embodiment, as shown in FIG. 5, the second protective structure 530 includes a plurality of third projections 513, and the third projections 513 are arranged in the middle region 110a at intervals.

In the embodiments of the present application, a plurality of third projections 513 arranged at intervals are disposed in the middle region 110a of the light receiving surface 101 of the solar cell, so that when the solar cells are stacked, the plurality of third bumps 513 can achieve a function of isolation and protecting two solar cells stacked up and down, thereby avoiding from friction and scratch on a light receiving surface 101 of a lower solar cell caused by electrodes 110 on an upper solar cell.

In an embodiment, as shown in FIG. 6, the solar cell body 100a has four sides 103, and a distance from a boundary (as shown by a dashed box in FIG. 6) of the edge region 110b close to the middle region 110a to the corresponding side 103 is D, satisfying: $2 \, \text{cm} \leq D \leq 5 \, \text{cm}$.

In the embodiments of the present application, the distance range from the boundary of the edge region 110b close to the middle region 110a to the corresponding edge of the solar cell body is set, so that effective isolation and protection can be formed in a particular area of the peripheral edge of the light receiving surface 101 by using the first protective structure 510, and an excessively large area caused by setting the first protective structure 510 can be prevented from affecting other structural designs of the solar cell.

It should be noted that, the boundary of the edge region 110b close to the middle region 110a is a track line formed at an interface between the edge region 110b and the middle region 110a.

In a specific application, the solar cell body 100a has four sides 103, and along a direction perpendicular to each side 103, a linear distance from a boundary corresponding to the side 103 to the side 103 may be measured to obtain a value of the distance D. The specific measurement manner may be set flexibly according to an actual situation. This is not limited in the embodiments of the present application. For example, the distance D from the boundary of the edge region 110b close to the middle region 110a to the corresponding side edge 103 may be set to any value such as 2 cm, 2.5 cm, 3 cm, 3.5 cm, 4 cm, 4.5 cm, or 5 cm, or a range between any two values.

In an embodiment, as shown in FIG. 5, along a thickness direction of the solar cell body 100a, a height H3 of the first protective structure 510 is equal to a height H4 of the second protective structure 530. The thickness direction refers to a direction from the light receiving surface 101 to the back surface 102 of the solar cell body 100a.

In the embodiments of the present application, the height of the first protective structure 510 is set to be equal to the height of the second protective structure 530, so that when solar cells are stacked, the first protective structure 510 and the second protective structure 530 on a surface of a lower solar cell can be both in contact with an upper solar cell, to evenly bear force between the two solar cells at various positions, thereby avoiding deformation damage caused by uneven local stress on the solar cells.

In an embodiment, as shown in FIG. 5, for value ranges of the height H3 of the first protective structure 510 and the height H4 of the second protective structure 530, refer to the value range of the isolation bumps in the first group of embodiments. The height of the first protective structure is H3, satisfying $2 \, \mu\text{m} \leq H3 \leq 80 \, \mu\text{m}$; and the height of the second protective structure is H4, satisfying $2 \, \mu\text{m} \leq H4 \leq 80 \, \mu\text{m}$. For beneficial effects corresponding to the value ranges, refer to the foregoing embodiments. Details are not described herein again. In some examples, the height of the first protective structure is H3, satisfying 10 $\mu$m ≤ H3 ≤ 40 $\mu$m; and the height of the second protective structure is H4, satisfying 10 $\mu$m ≤ H4 ≤ 40 $\mu$m.

In an embodiment, as shown in FIG. 5, the first protective structure 510 and the second protective structure 530 are disposed on the light receiving surface 101 of the solar cell body 100a, and the back surface 102 of the solar cell body 100a is provided with a plurality of electrodes 110 arranged at intervals. Along a direction from the light receiving surface 101 to the back surface 102, an orthographic projection of the first protective structure 510 is staggered from an orthographic projection of the electrodes 110; and/or an orthographic projection of the second protective structure 530 is staggered from an orthographic projection of the electrodes 110.

In the embodiments of the present application, it is set that the orthographic projection of the first protective structure 510 is staggered from the orthographic projection of the electrodes 110, and/or the orthographic projection of the second protective structure 530 is staggered from the orthographic projection of the electrode 110, so that in a solar cell stacking process, a protective structure on a surface of a lower solar cell is in contact with an area without electrodes 110 on a back surface 102 of an upper solar cell, thereby achieving a function of isolation the two solar cells, and avoiding mutual interference between the protective structure and the electrodes 110.

A structure of a solar cell in the third group of embodiments in the first aspect of the present application is described in detail in the following with reference to FIG. 7.

In this embodiment, the isolation member includes an isolation film 540. Referring to FIG. 7, FIG. 7 is a schematic structural diagram of a solar cell according to an embodiment of the present application. The solar cell includes a solar cell body and an isolation film 540. The isolation film 540 is disposed on a light receiving surface of the solar cell body. A hollow structure 520 is disposed on the isolation film 540.

In some examples, electrodes 110 are disposed on a back surface of the solar cell body 100a.

In some embodiments of the present application, the isolation film 540 in the solar cell is provided with the hollow structure 520. The hollow structure 520 can reduce costs and reduce blocking of light, and properly ensure the photoelectric conversion efficiency of the solar cell.

In an embodiment, in case of a room temperature, the isolation film 540 is a solid member. In case of a high temperature, the isolation film 540 is pyrolyzed and vaporized. The case of the high temperature is at least one of a drying and curing process or a stringing process in subsequent processing of the solar cell.

In this case, the isolation film 540 has stability at the room temperature, to prevent the isolation film 540 from being in a fused flowing state at the room temperature. The isolation film 540 may have an isolation function, to prevent the light receiving surface of the solar cell body 100a from being damaged. During subsequent processing, for example, at least one of the drying and curing process and the stringing process of the solar cell, the solar cell is in the high temperature. The isolation film 540 is pyrolyzed and vaporized under the high temperature, or a material used for the isolation film 540 may be the same as a material of the packaging adhesive film, and can well match subsequent manufacture of the photovoltaic module, that is, can be well fused with the packaging adhesive film in a subsequent laminating process. Therefore, the isolation film 540 does not need to be removed separately, and subsequent processes of transferring and processing the solar cell are simpler, so that manufacturing costs of the photovoltaic module can be effectively reduced, and problems such as costs and a photoelectric conversion rate of the solar cell can be resolved.

In an embodiment, a melting point temperature of the isolation film 540 is greater than or equal to 70°C, and less than or equal to 130°C; and a boiling point temperature of the isolation film 540 is greater than or equal to 170°C, and less than or equal to 340°C.

When the melting point temperature and the boiling point temperature of the isolation film 540 of the solar cell in the embodiments of the present application are within the foregoing ranges, the isolation film 540 has stability in a room-temperature environment, to prevent the isolation film 540 from being in a fused flowing state in the room temperature environment. In addition, the isolation film 540 is pyrolyzed subsequently at a component manufacturing end of the solar cell, so that the isolation film 540 does not need to be removed separately, and processes of subsequent transferring and processing of the solar cell are simpler, thereby effectively reducing manufacturing costs of the photovoltaic module.

It may be understood that, the melting point temperature of the isolation film 540 is specifically selected according to an application requirement. For example, the melting point temperature of the isolation film 540 is any value of 70°C, 80°C, 90°C, 100°C, 105°C, 110°C, 120°C, or 130°C. The boiling point temperature of the isolation film 540 is any value of 170°C, 180°C, 190°C, 200°C, 210°C, 220°C, 230°C, 250°C, 270°C, 290°C, 300°C, 310°C, 320°C, 330°C, or 340°C.

In an embodiment, at the room temperature, the isolation film 540 is a solid member. In the laminating process in subsequent processing of the solar cell, the isolation film 540 is cross-linked to the packaging adhesive film. In this case, the isolation film 540 has stability at the room temperature, to prevent the isolation film 540 from being in a fused flowing state at the room temperature. The isolation film 540 may have an isolation function, to prevent the light receiving surface of the solar cell body 100a from being damaged. In the laminating process in subsequent processing of the solar cell, the isolation film 540 is melted and is cross-linked to the packaging adhesive film. Therefore, the isolation film 540 does not need to be removed separately, and subsequent processes of transferring and processing the solar cell are simpler, so that manufacturing costs of the photovoltaic module can be effectively reduced.

In an embodiment, in another embodiment of the present application, the melting point temperature of the isolation film 540 is greater than or equal to 130°C, and less than or equal to 160°C.

It may be understood that, the melting point temperature of the isolation film 540 is specifically selected according to an application requirement. For example, the melting point temperature of the isolation film 540 is any value of 130°C, 135°C, 140°C, 145°C, 148°C, 150°C, 155°C, or 160°C.

Specifically, to keep isolation stability of the isolation film 540 and avoid random change of a form of the isolation film 540, a melting point of a used material generally should not be less than 70°C, to avoid a case in which the isolation film 540 is in a fused flowing state in the room temperature environment. In addition, in order not to deform or damage the solar cell body 100a or the like due to an excessively high heating temperature in a subsequent laminating process, the melting point generally should not be higher than 300°C.

A material of the isolation film 540 is not specifically limited in the embodiments of the present application. For example, the isolation film 540 is a thin polyvinyl alcohol (PVA) film, and the PVA has a boiling point of approximately 180°C. The PVA film is disposed on the solar cell body 100a, and the PVA film is in a solid state at the room temperature. After an insulating adhesive and/or a gray adhesive is applied at the component end, there is a drying and curing stage at the component end, and a drying and curing temperature may be 180°C to 340°C. In this stage, the PVA film is pyrolyzed, so that the isolation film 540 does not need to be removed. Therefore, the subsequent process of transferring and processing the solar cell is simpler, and the manufacturing costs of the photovoltaic module can be effectively reduced. After the PVA thin film is pyrolyzed, a trace or no trace is left on the solar cell body 100a, and the trace left on the solar cell body 100a may be used as an identifier of the light receiving surface of the solar cell body 100a.

The material of the isolation film 540 is not specifically limited in the embodiments of the present application. For example, the material of the isolation film 540 may alternatively be ethylene-vinyl acetate copolymer (EVA), or polyolefin elastomer (POE). An EVA isolation film or a POE isolation film is disposed on the light receiving surface of the solar cell body 100a; and when an EVA isolation film or the POE isolation film is in the room temperature environment, a solid-state form of the EVA isolation film or the POE isolation film is stable, so that the EVA isolation film or the POE isolation film can well perform an isolation function. The EVA isolation film or the POE isolation film does not need to be removed. During component laminating, the EVA isolation film or the POE isolation film and a component encapsulating adhesive film (a packaging adhesive film for short) are directly laminated and cross-linked, to avoid waste of the isolation film 540, and further reduce a quantity of packaging adhesive films, thereby reducing laminating costs. The isolation film 540 is consistent with the packaging adhesive film, to well match subsequent manufacture of the photovoltaic module, in other words, the isolation film 540 can be well fused with the packaging adhesive film in the subsequent laminating process. In this way, the processes of subsequent transferring and processing the solar cell are simpler, and this can effectively reduce manufacturing costs of forming the photovoltaic module.

It may be understood that, the material of the isolation film 540 may be selected according to an application requirement, for example, at least one of polyvinyl alcohol, ethylene-vinyl acetate copolymer, and polyolefin elastomer is selected.

In some examples, during actual application, a thickness of the isolation film 540 needs to be greater than a height of main grid lines or the insulating adhesive.

Specifically, the solar cell is a back contact solar cell, and when the solar cell includes main grid lines, the thickness of the isolation film 540 is higher than the height of the main grid lines. When the solar cell includes fine grid lines or an isolating adhesive, the thickness of the isolation film 540 is higher than the height of the fine grid lines or the isolating adhesive.

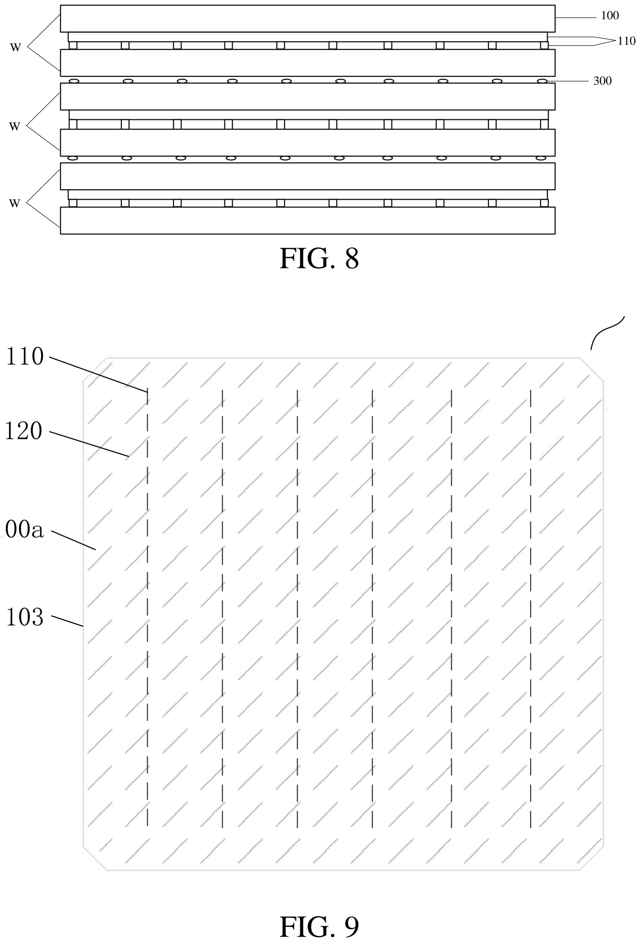

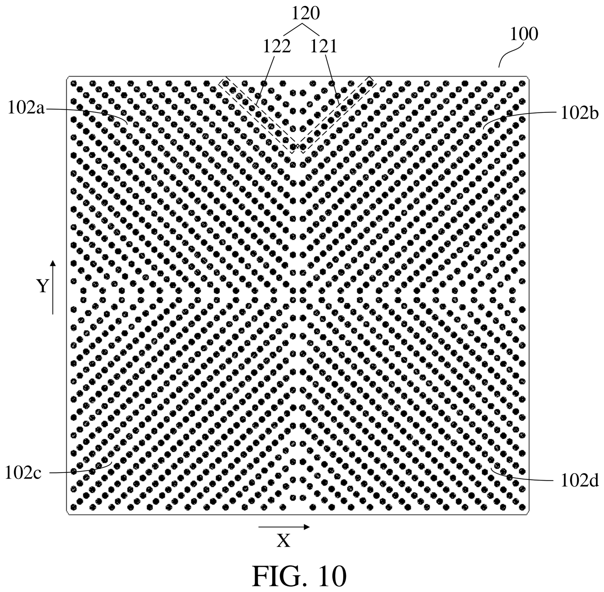

A structure of a solar cell in the fourth group of embodiments in the first aspect of the present application is described in detail in the following with reference to FIG. 9 and FIG. 10.

In this group of embodiments, as shown in FIG. 9, a solar cell 100 according to some embodiments of the present application includes: a solar cell body 100a, the solar cell body 100a has a light receiving surface and a back surface, the back surface is provided with electrodes 110, the light receiving surface is provided with a plurality of isolation members 120 arranged at intervals, and an extension directions of at least some of the isolation members 120 is staggered with an extension direction of the electrodes 110.

In the embodiments of the present application, by disposing the plurality of isolation members 120 arranged at intervals on the light receiving surface 101 of the solar cell 100, a light receiving surface 101 of a solar cell 100 can be separated and protected from being scuffed by electrodes 110 on an adjacent solar cell 100 during a stacking process of solar cells 100. In addition, in comparison with disposing an isolation film layer on an entire surface, blocking on the light receiving surface 101 of the solar cell 100 can be reduced, and conversion efficiency of the solar cell 100 can be improved. In addition, the extension direction of at least some of the isolation members 120 is staggered with the extension direction of the electrodes 110, to ensure that some of the isolation members 120 can always form isolation and support for the electrodes 110 on the adjacent solar cell 100 when the solar cells 100 are stacked, thereby further improving an isolation and protection effect on the light receiving surface 101.

In some embodiments, as shown in FIG. 9 and FIG. 10, the isolation members 120 are formed by a plurality of dotted bumps and/or a plurality of linear bumps sequentially arranged at intervals along a preset direction, and the preset direction is the extension direction of the isolation members.

In the embodiments of the present application, the isolation members 120 are formed by a plurality of dotted bumps and/or a plurality of linear bumps arranged at intervals along the preset direction, so that while isolation and protecting the surface of the solar cell 100 by using the isolation members 120, an area covered by the isolation members 120 on the surface of the solar cell body 100a can also be reduced, and a preparing material of the isolation members can be reduced.

In addition, in a process of preparing a photovoltaic module from the solar cell 100, generally, a polymer layer usually needs to be formed on a surface of the solar cell body 100a, and the isolation members 120 are located between the polymer layer and the solar cell body 100a. By reducing a covering area of the isolation members 120 on the surface of the solar cell body 100a, this helps increase a contact area between the polymer layer and the solar cell body 100a, thereby reducing impact of disposing the isolation members 120 on an interfacial binding force between the polymer layer and the solar cell body 100a.

Specifically, a plurality of isolation members 120 may be disposed on the surface of the solar cell body 100a. Each isolation member 120 is formed by a plurality of dotted bumps sequentially arranged at intervals, a plurality of linear bumps sequentially arranged at intervals, or a plurality of dotted bumps and a plurality of linear bumps sequentially arranged at intervals.

For example, as shown in FIG. 10, a plurality of dotted bumps in a dashed line box forms an isolation member 120, and further, a plurality of isolation members 120 may be formed on the surface of the solar cell body. A direction in which the plurality of dotted bumps in each isolation member 120 are sequentially arranged is an extension direction of the isolation member 120.

It may be understood that, when the isolation member 120 is formed by a plurality of dotted bumps, a row formed by a plurality of dotted bumps close to each other is referred to as an isolation member 120. The dotted bump means that a difference between a size of a corresponding bump structure along the extension direction of the isolation member 120 and a size of a corresponding bump structure perpendicular to the extension direction of the isolation member 120 is small. The linear bump means that a difference between a size of a corresponding bump structure along the extension direction of the isolation member 120 and a size of a corresponding bump structure perpendicular to the extension direction of the isolation member 120 large.

In some other embodiments, as shown in FIG. 9, the isolation member 120 is a continuously extending strip-shaped bump. An extension direction of the strip-shaped bump is the extension direction of the isolation member 120.

In the embodiments of the present application, the isolation member 120 is disposed as the continuously extending strip-shaped bump, thereby facilitating actual design and processing. In addition, the strip-shaped bump has a large binding force with the surface of the solar cell body 100a, and is not easily damaged during use, thereby improving the isolation and protection effect on the solar cell.

In an embodiment, as shown in FIG. 10, the isolation members 120 includes a plurality of first isolation members 121 arranged at intervals. Extension directions of the plurality of first isolation members 121 are the same, and the extension directions of the first isolation members 121 are staggered with the extension direction of the electrodes 110. In this way, actual processing and manufacturing are convenient, and an effective isolation and protecting function can be formed on the light receiving surface 101 by using the plurality of first isolation members 121.

In an embodiment, as shown in FIG. 10, the isolation members 120 further includes a plurality of second isolation members 122, the plurality of second isolation members 122 are arranged at intervals, and an extension direction of the second isolation members 122 is separately staggered with the extension direction of the first isolation members 121 and the extension direction of the electrodes 110.

It may be understood that, if the isolation members 120 extending in only a single direction is disposed on the light receiving surface 101 of the solar cell 100, during a stacking process, when a solar cell 100 dropped from above is offset by an angle, there may be a possibility that electrodes 110 on a back surface 102 of the upper solar cell 100 is exactly parallel to isolation members 120 on a light receiving surface 101 of a lower solar cell 100. In this case, there is a possibility that the isolation members 120 are offset into gaps between the electrodes 110, so that the isolation members 120 cannot form effective isolation and support for the electrodes 110. Consequently, the electrodes 110 are directly in contact with the light receiving surface 101 of the lower solar cell 100, easily causing the light receiving surface 101 of the lower solar cell 100 to be scuffed. It should be noted that, when the electrodes 110 are busbars, fingers are further disposed at a position perpendicular to the busbars. Alternatively, the solar cell 100 may have only fingers and no busbar. In this case, the electrodes 110 are the fingers. In the embodiments of the present application, as shown in FIG. 10, the first isolation members 121 and the second isolation members 122 are disposed, so that the extending directions of the first isolation members 121 and the second isolation members 122 are staggered with the extending direction of the electrodes 110, and the extending directions of the first isolation member 121 and the second isolation member 122 are also staggered. In this way, during a stacking process of solar cells 100, when a solar cell 100 dropped from above is offset, even if electrodes on the upper solar cell 100 is parallel to one of the first isolation members 121 and the second isolation members 122, the other can be used for effectively isolation and supporting the electrodes 110, thereby avoiding a problem of isolation failure caused by the electrodes 110 in the upper solar cell 100 being exactly parallel to the isolation members 120 in the lower solar cell 100, and improving the isolation and protection function on the surface of the solar cell 100.

In an embodiment, as shown in FIG. 10, the light receiving surface 101 includes four regions, which are respectively a first region 102a, a second region 102b, a third region 102c, and a fourth region 102d. The first region 102a and the second region 102b are arranged along a first direction X, and the third region 102c and the fourth region 102d are arranged along the first direction X. The first region 102a and the third region 102c are arranged along a second direction Y, the second region 102b and the fourth region 102d are arranged along the second direction Y, and the first direction X is perpendicular to the second direction Y. The first isolation members 121 are disposed in the second region 102b and the third region 102c, and the second isolation members 122 are disposed in the first region 102a and the fourth region 102d.

In the embodiments of the present application, the light receiving surface 101 of the solar cell body 100a is divided into four regions. In the four regions, structures of isolation members 120 in two regions distributed along a diagonal line are the same, and extension directions of isolation members 120 in two adjacent regions are different. In this way, in a stacking process of the solar cells 100, regardless of deflection or bending of the solar cells 100, it can be ensured that isolation members 120 and electrodes 110 between two adjacent solar cells 100 can overlap to a maximum extent, thereby improving the function of isolation and protecting the light receiving surface 101 of the solar cell 100.

It should be noted that the locations of the first isolation members 121 and the second isolation members 122 in the regions in the embodiments of the present application are interchangeable, and may be flexibly set according to an actual situation. This is not limited in the embodiments of the present application.

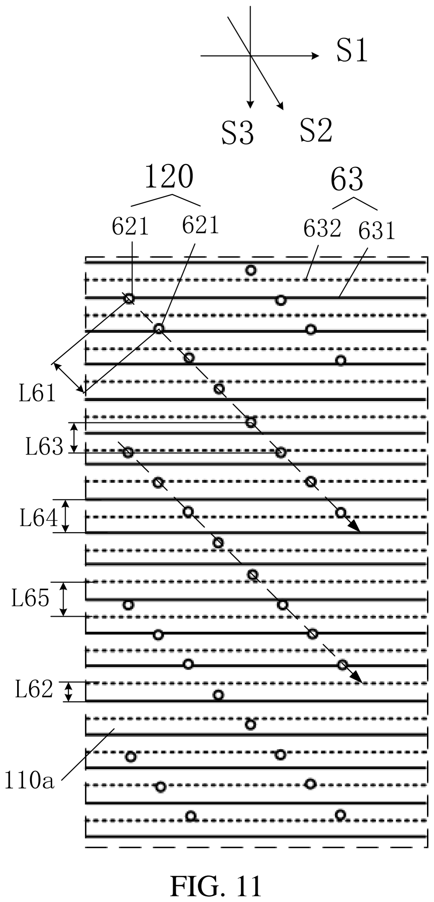

A structure of a solar cell in the fifth group of embodiments in the first aspect of the present application is described in detail in the following with reference to FIG. 11 to FIG. 13.

In this group of embodiments, a solar cell includes: a solar cell body 100a, including a first surface and a second surface opposite to the first surface; a plurality of fingers 63 disposed on the first surface of the solar cell body 100a; and a plurality of isolation members 120, disposed on the first surface and/or the second surface of the solar cell body 100a. As shown in FIG. 11, an extension direction of the isolation members 120 is intersected with an extension direction of the fingers 63, and the isolation members 120 include a plurality of isolation bumps 621 arranged along the extension direction of the isolation members 120.

It should be noted that, in the embodiments of the present application, a plurality of isolation bumps 621 close to each other and continuously disposed in a row forms an isolation member 120. As shown in FIG. 11, a plurality of isolation bumps 621 stringed by a dashed arrow line are combined to form an isolation member 120, that is, FIG. 11 shows five isolation members 120.

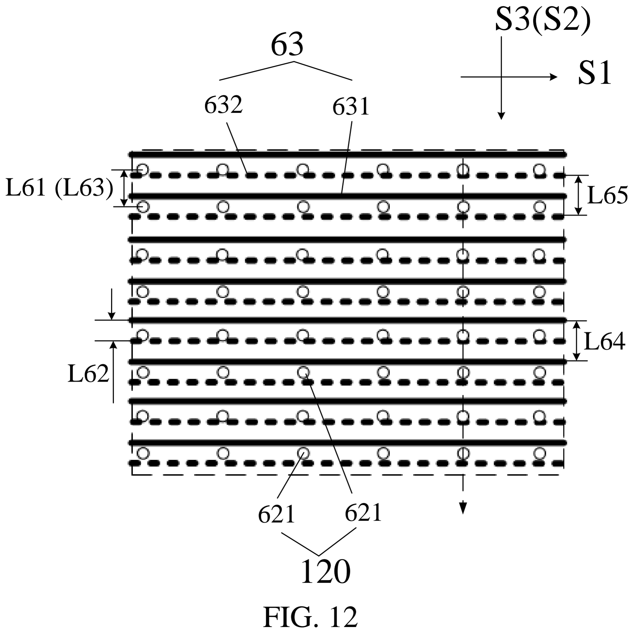

Specifically, as shown in FIG. 11, the extension direction of the fingers 63 is parallel to a direction S1, the extension direction of the isolation members 120 is parallel to a direction S2, and the extension direction of the isolation members 120 and the extension direction of the fingers 63 may be not perpendicular. A plurality of isolation members 120 are arranged at intervals along a direction S3 perpendicular to the fingers 63, and the direction S2 is intersected with the direction S3. As shown in FIG. 12, the extension direction of the isolation members 120 may be perpendicular to the extension direction of the fingers 63, and the direction S2 is the same as the direction S3.

In some examples, a distance between two adjacent isolation bumps 621 in a same isolation member 120 in the extension direction of the isolation members 120 is greater than a distance between two adjacent fingers 63.

In the embodiments of the present application, the fingers 63 are arranged on the first surface of the solar cell body 100a, and the isolation members 120 are arranged on the first surface and/or the second surface of the solar cell body 100a. In this way, in a process of stacking and transferring solar cells, the isolation members 120 can be located between two adjacent solar cell bodies 100a, to perform an isolation and protection function, to prevent fingers, busbars, end lines, pads, or the like on one solar cell from scuffing a second surface of another solar cell. Based on the protection function of the isolation members 120, because the isolation members 120 include the plurality of isolation bumps 621 along the extension direction of the isolation members 120, and the distance between two adjacent isolation bumps 621 in the same isolation member 120 in the extension direction of the isolation members 120 is greater than the distance between two adjacent fingers 63, arrangement of the isolation bumps 621 is sparse. In this way, manufacturing costs of the isolation members 120 can be saved, and a quantity of isolation bumps 621 that are disposed is reduced, so that blocking can be reduced, and a light absorbing rate of the solar cell body 100a can be improved.

Specifically, the busbars, the finger 63, the end lines, and the pads are all disposed on the first surface of the solar cell body 100a. The busbars are main grids on the solar cell body 100a, and the fingers 63 are fine grids on the solar cell body 100a. In addition, the fingers 63 may be positive grid lines or negative grid lines.

Specifically, the isolation members 120 may be disposed on the first surface of the solar cell body 100a, the isolation members 120 may be disposed on the second surface of the solar cell body 100a, or the isolation members 120 may be disposed on both the first surface and the second surface of the solar cell body 100a. In the embodiments of the present application, the fingers 63 and the isolation members 120 may be disposed on a same surface of the solar cell body 100a, or the fingers 63 and the isolation members 120 may be respectively disposed on two opposite surfaces of the solar cell body 100a.

In some embodiments, the extension direction of the isolation members 120 may be intersected with the extension direction of the fingers 63, to ensure that at least some of the isolation members 120 can always perform a function of isolation and protecting a light receiving surface on an adjacent solar cell when the solar cells are stacked.

In some embodiments, extension directions of all the isolation members 120 may be the same.

In some other embodiments, extension directions of the plurality of isolation members 120 may not be completely the same, as shown above with reference to FIG. 10.

Specifically, the isolation members 120 may include a plurality of isolation bumps 621 arranged at intervals along the extension direction of the isolation members 120. This can reduce coverage ratios of the isolation members 120 on the first surface and/or the second surface, and can reduce manufacturing costs of the isolation members 120. In addition, a coverage ratio on the light receiving surface of the solar cell is reduced, so that blocking on the light receiving surface of the solar cell can be reduced, thereby improving the photoelectric conversion efficiency of the photovoltaic module.

In some examples, the distance between two adjacent isolation bumps 621 in the same isolation member 120 in the extension direction of the isolation members 120 is greater than the distance between two adjacent fingers 63, and because the isolation bumps 621 are disposed sparsely, it is convenient to further reduce the coverage ratio of the isolation bumps 621 on the first surface and/or the second surface.

For example, as shown in FIG. 11 to FIG. 12, the fingers 63 extend along the direction S1, the isolation members 120 extend along the direction S2, a distance between two adjacent isolation bumps 621 in a same isolation member 120 in the direction S2 is L61, a distance between two adjacent fingers 63 is L62, and L61 > L62.

It should be noted that, in the present application, the distance between the two adjacent fingers 63 is a width of a gap between the two adjacent fingers 63 in the direction S3, that is, a distance between boundaries of the two adjacent fingers 63 in the direction S3. The distance between two adjacent isolation bumps 621 may be a distance between centers of the two adjacent isolation bumps 621, that is, a distance between circle centers of the two adjacent isolation bumps 621, or may be a width of a gap between the two adjacent isolation bumps 621, that is, a distance between boundaries of the two adjacent isolation bumps 621.

For example, the distance between two adjacent isolation bumps 621 in the same isolation member 120 in the extension direction of the isolation members 120 may be the distance between the circle centers of the two adjacent isolation bumps 621 in the same isolation member 120 in the extension direction of the isolation members 120, or a minimum distance between two adjacent isolation bumps 621 in the same isolation member 120 in the extension direction of the isolation members 120.

The distance of two adjacent isolation bumps 621 in a same isolation member 120 in the direction perpendicular to the fingers 63 may be a distance between circle centers of the two adjacent isolation bumps 621 in the same isolation member 120 in the direction perpendicular to the fingers 63, or a minimum distance between the two adjacent isolation bumps 621 in the same isolation member 120 in the direction perpendicular to the fingers 63.

In the embodiments of the present application, the fingers 63 may be regularly arranged on the first surface. The isolation members 120 may be regularly arranged on the first surface and/or the second surface, or the isolation members 120 may be regularly arranged in at least one local region on the first surface and/or the second surface, and there is no isolation member 120 in other regions, or isolation members 120 in the other regions are randomly distributed. Specifically, as shown in FIG. 11 and FIG. 12, only a local region of the first surface and/or the second surface is shown. Refer to the figures for the disposition of the isolation members 120 and the fingers 63. Details are not described herein again in the present application.

In some embodiments of the present application, a distance between two adjacent isolation bumps 621 in a same isolation member 120 in a direction perpendicular to the fingers 63 is greater than a distance between two adjacent fingers 63, so that sparsity of the isolation bumps 621 can be improved while isolation and protection of the isolation members 120 on the light receiving surface of the solar cell is ensured, thereby reducing manufacturing costs of the isolation bumps 621 and improving a light absorption rate of the solar cell.

Specifically, as shown in FIG. 11 and FIG. 12, a distance between two adjacent isolation bumps 621 in a same isolation member 120 in the direction S3 perpendicular to the fingers 63 is L63, a distance between two adjacent fingers 63 is L62, and L63 > L62.

In some other embodiments of the present application, the distance between two adjacent isolation bumps 621 in the same isolation member 120 in the direction perpendicular to the fingers 63 may alternatively be less than the distance between two adjacent fingers 63, to more effectively prevent fingers 63, busbars, end lines, pads, or the like of a solar cell from scuffing another solar cell stacked with the solar cell.

In some embodiments, the plurality of fingers 63 includes first fingers 631 and second fingers 632 that are sequentially and alternately arranged along the direction perpendicular to the fingers 63. One of the first finger 631 and the second finger 632 is a positive grid line, and the other is a negative grid line.

In an embodiment, the distance between two adjacent isolation bumps 621 in a same isolation member 120 in the extension direction of the isolation members 120 is greater than the distance between two adjacent first fingers 631. In this way, the distance between two adjacent isolation bumps 621 in a same isolation member 120 in the extension direction of the isolation members 120 is greater than the distance between fingers 63 of a same polarity, so that sparsity of the isolation bumps 621 can be further increased, a quantity of the isolation bumps 621 is reduced, manufacturing costs of the isolation bumps 621 is reduced, a coverage ratio of the isolation bumps 621 on the solar cell body 100a is reduced, and the light absorption rate of the solar cell body 100a is improved.

Specifically, as shown in FIG. 11 and FIG. 12, the distance between two adjacent first fingers 631 is L64, and L61 > L64.

In some other embodiments, the distance between two adjacent isolation bumps 621 in a same isolation member 120 in the extension direction of the isolation members 120 is less than the distance between two adjacent first fingers 631, to more effectively prevent fingers 63, busbars, end lines, pads, or the like of a solar cell from scuffing another solar cell stacked with the solar cell.

In an embodiment, the distance between two adjacent isolation bumps 621 in a same isolation member 120 in the extension direction of the isolation members 120 is greater than a distance between two adjacent second fingers 632. In this way, the distance between two adjacent isolation bumps 621 in a same isolation member 120 in the extension direction of the isolation members 120 is greater than a distance between fingers 63 of a same polarity, so that sparsity of the isolation bumps 621 can be further increased, and manufacturing costs of the isolation bumps 621 can be reduced.

Specifically, as shown in FIG. 11 and FIG. 12, the distance between two adjacent second fingers 632 is L65, and L61 > L65.

In some other embodiments, the distance between two adjacent isolation bumps 621 in a same isolation member 120 in the extension direction of the isolation members 120 is less than the distance between two adjacent second finger 632, to more effectively prevent fingers 63, busbars, end lines, pads, or the like of a solar cell from scuffing another solar cell stacked with the solar cell.

In an embodiment, the distance between two adjacent isolation bumps 621 in a same isolation member 120 in the direction perpendicular to the fingers 63 is greater than the distance between two adjacent first fingers 631. In this way, the distance between two adjacent isolation bumps 621 in a same isolation member 120 in the direction perpendicular to the fingers 63 is greater than a distance between fingers 63 of a same polarity, to further increase sparsity of the isolation bumps 621, reduce a quantity of the isolation bumps 621, reduce manufacturing costs of the isolation bumps 621, and improve the light absorption rate of the solar cell.

Specifically, as shown in FIG. 11 to FIG. 12, the distance between two adjacent isolation bumps 621 in a same isolation member 120 in the direction S3 perpendicular to the fingers 63 is L63, the distance between two adjacent first fingers 631 is L64, and L63 > L64.

In an embodiment, the distance between two adjacent isolation bumps 621 in a same isolation member 120 in the direction perpendicular to the fingers 63, is greater than the distance between two adjacent second fingers 632. In this way, the distance between two adjacent isolation bumps 621 in a same isolation member 120 in the direction perpendicular to the fingers 63 is greater than the distance between fingers 63 of a same polarity, so that sparsity of the isolation bumps 621 can be further increased, manufacturing costs of the isolation bumps 621 can be reduced, and the light absorption rate of the solar cell can be improved.

Specifically, as shown in FIG. 11 and FIG. 12, the distance between two adjacent isolation bumps 621 in a same isolation member 120 in the direction S3 perpendicular to the fingers 63 is L63, the distance between two adjacent second fingers 632 is L65, and L63 > L65.

In some other embodiments of the present application, the distance between two adjacent isolation bumps 621 in a same isolation member 120 in the direction perpendicular to the fingers 63 may alternatively be less than the distance between two adjacent first fingers 631, and/or the distance between two adjacent isolation bumps 621 in a same isolation member 120 in the direction perpendicular to the fingers 63 may alternatively be less than the distance between two adjacent second finger 632, so that the distance between two adjacent isolation bumps 621 in a same isolation member 120 in the direction perpendicular to the fingers 63 is less than the distance between two fingers 63 of a same polarity, to more effectively prevent fingers, busbars, end lines, pads, or the like of a solar cell from scuffing another solar cell stacked with the solar cell.

In some embodiments, a height of the isolation bumps 621 is greater than or equal to a height of the fingers 63. In this way, under an isolation effect of the isolation bumps 621, the isolation bumps 621 may be directly in contact with a first surface of another stacked solar cell 100a, and the fingers 63 may be unfounded. Alternatively, the isolation bumps 621 may be directly in contact with fingers 63 on another stacked solar cell, thereby effectively preventing the fingers 63 from scuffing and damaging a light receiving surface of the solar cell.

In some examples, the isolation members 120 are disposed on the second surface, and a projection of at least one isolation bump 621 on the first surface has an overlapping area with the fingers 63. By using the technical solution, when a plurality of solar cells are stacked, it is easy to make at least one isolation bump 621 on one solar cell be in contact with a finger 63 on another solar cell. In this way, it can be effectively prevented that fingers, busbars, pads, end lines, and the like scratch the surface of the solar cell body 100a. Certainly, in some other examples, the projection of the isolation bump 621 on the first surface and the fingers 63 may not have an overlapping area. In this case, a height and a quantity of the isolation bumps 621, an arrangement manner of the plurality of isolation bumps 621, a stacking manner of a plurality of solar cells, and the like may be set, so that the isolation bumps 621 can prevent the fingers, the busbars, the pads, the end lines, and the like from scuffing the surface of the solar cell body 100a.

In some embodiments, the isolation members 120 may be arranged on the first surface, and the isolation bumps 621 may be spaced apart from the fingers 63, to avoid a case in which the isolation bumps 621 affect electrical connection between a busbar or an interconnection member and the fingers 63. The interconnection member may be a soldering tape, a conductive tape, or the like.

In an embodiment, for a height range of the isolation bumps 621, refer to the foregoing other groups of embodiments. Details are not described herein again.

In some embodiments, the solar cell includes fingers and pads, and a height of the isolation bumps 621 is greater than or equal to a height of the higher one of the fingers 63 and the pads. In this way, fingers and pads of one solar cell can be prevented from being in contact with a light receiving surface of another solar cell stacked with the solar cell, to ensure that the isolation bumps 621 can perform an isolation and protection function, to prevent the fingers and the pads of one solar cell from scuffing the light receiving surface of the another solar cell.

Specifically, the pad is configured to be electrically connected to the interconnection member, to connect different solar cells.

In some other embodiments, the solar cell includes fingers 63, pads, and busbars. The busbars are electrically connected to a plurality of fingers 63 and are configured to bus collected currents. The pads are electrically connected to the busbars. The height of the isolation bumps 621 is greater than or equal to a height of the highest one of the pads, the fingers 63, and the busbars. In this way, pads, fingers 63, and busbars of a solar cell can be prevented from being in contact with a light receiving surface of another stacked solar cell, to ensure that the isolation bumps 621 can perform the isolation and protection function, and avoid a case in which the pads, the fingers 63, and the busbars on the solar cell from scuffing the light receiving surface of the another solar cell.

In some other embodiments, the solar cell includes fingers, pads, and end lines. Each of a plurality of fingers located at an edge of the solar cell body 100a includes a plurality of finger segments sequentially arranged along the extension direction of the fingers. The end lines are electrically connected to the plurality of finger segments located at the edge of the solar cell body 100a. Herein, a plurality of fingers located in a middle region of the solar cell body is continuously arranged. The pads are disposed on the end lines and the continuous fingers. The height of the isolation bumps 621 is greater than a height of the highest one of the pads, the fingers 63, and the end lines. In this way, fingers, pads, and end lines of a solar cell can be prevented from being in contact with a light receiving surface of another solar cell, to ensure that the isolation bumps 621 can perform the isolation and protection function, to prevent the fingers, the pads, and the end lines of the solar cell from scuffing the light receiving surface of the another solar cell.

Specifically, the end lines are configured to connect fingers 63 of a same polarity. The end lines may include a first end line connecting a plurality of first sub-fingers 6311, and a second end line connecting a plurality of second sub-fingers 6321.

In the embodiments of the present application, it is considered that during design of the isolation bumps, if a size of the isolation bumps 621 is excessively small, it is difficult to implement in process; if a size of the isolation bumps 621 is excessively large, it causes too much light shielding, which is not beneficial to light absorption of the solar cell body 100a. Therefore, in some embodiments, a maximum size of the isolation bump 621 is d. When a projection of the isolation bump 621 on the first surface is a circle or an approximate circle, the maximum size is a diameter of the isolation bump 621, where $50\ \mu m \le d \le 2000\ \mu m$. In the embodiments of the present application, the diameter of the isolation bump 621 is limited, so that manufacturing difficulty of the isolation member 120 is low, and a light absorbing capability of the solar cell body 100a can be ensured. For maximum sizes of isolation bumps in other embodiments, refer to this embodiment.

For example, the diameter of the isolation bump 621 may be $50\ \mu m$, $255\ \mu m$, $380\ \mu m$, $500\ \mu m$, $850\ \mu m$, $1150\ \mu m$, $1500\ \mu m$, $1860\ \mu m$, $1900\ \mu m$, $2000\ \mu m$, or the like.

It is considered in the present application that, if a coverage ratio of the isolation bumps 621 on the first surface and/or the second surface is excessively small, an effect of preventing the surface of the solar cell body 100a from being scuffed by the isolation bumps 621 may be poor; if a coverage ratio of the isolation bumps 621 on the first surface and/or the second surface is excessively large, it causes severe light shielding, which is not beneficial to light absorption of the solar cell body 100a. Therefore, in some embodiments, the coverage ratio of the isolation bumps 621 on the first surface and/or the second surface is designed to be S81, where $0.5 \le S81 \le 10\%$, to effectively ensure the effect of preventing the surface of the solar cell body 100a from being scuffed by the isolation bumps 621, and ensure the light absorbing capability of the solar cell body 100a. In other embodiments, for a coverage ratio of the isolation member, refer to this embodiment.

Specifically, when the isolation members 120 are arranged on both the first surface and the second surface, a coverage ratio of the isolation bumps 621 on the first surface may be the same as or different from a coverage ratio of the isolation bumps 621 on the second surface. This is not specifically limited in the embodiments of the present application.

For example, the coverage ratio of the isolation bumps 621 on the first surface or the second surface by may be 0.5%, 1.2%, 2%, 3.6%, 4.1%, 5%, 6.5%, 7%, 7.8%, 8%, 9.3%, 10%, or the like.

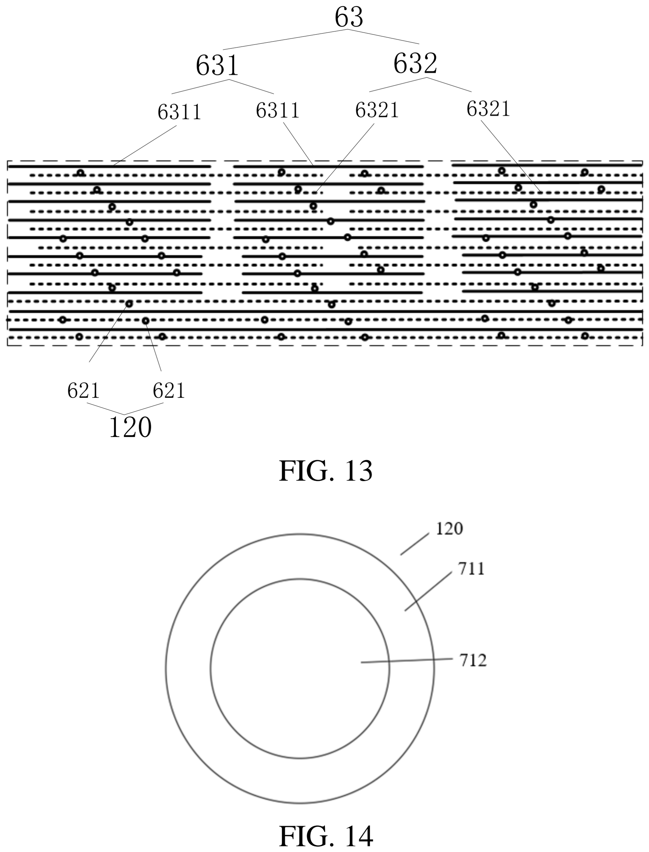

A structure of a solar cell in the sixth group of embodiments in the first aspect of the present application is described in detail in the following with reference to FIG. 14 to FIG. 17.

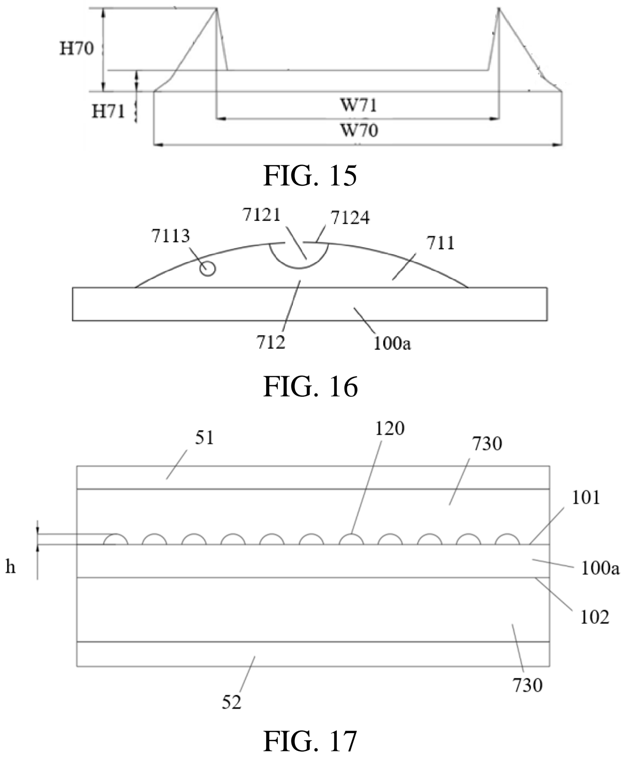

In this group of embodiments, a solar cell includes a solar cell body 100a, and a plurality of isolation members 120 arranged at intervals are disposed on at least one surface of the solar cell body 100a. As shown in FIG. 14, the isolation members 120 include a central portion 712 and a peripheral portion 711 disposed around the central portion 712. As shown in FIG. 16, a surface of the central portion 712 away from the solar cell body 100a has a recess 7121, and in a direction perpendicular to the solar cell body 100a, a minimum height of the central portion 712 is H71, and a maximum height of the isolation members 120 is H70, satisfying: $0 < H71 \leq \frac{2}{3}H70$.

Because the recess 7121 is provided in the central portion 712, and the minimum height H71 of the central portion 712 and the maximum height H70 of the isolation members 120 satisfy the foregoing relationship, when the isolation members 120 are in contact with a surface of a solar cell of an upper photovoltaic module, pressing action of adjacent solar cells causes deformation of the isolation members 120 and evacuates air in the recess 7121, and the isolation members 120 perform a negative pressure absorption action to attract and fix the two adjacent solar cells together, thereby avoiding a situation of inclination in a process of stacking and transferring a plurality of solar cells, and further avoiding that the isolation members 120 move relative to an adjacent solar cell, scuffing the solar cell or causing a hidden crack. Certainly, it may be understood that, the recess does not prevent isolation of the solar cells during subsequent laminating. In addition, when the photovoltaic module is used, the recess can increase an overall light transmittance of the isolation members, so that more light is irradiated on the solar cell, thereby increasing electricity generation efficiency of the solar cell. Further, the arrangement of the recess 7121 may further reduce a quantity of used adhesive materials, and reduce production costs of the solar cell.

It may be understood that, a relationship between the minimum height H71 of the central portion 712 and the maximum height H70 of the isolation members 120 may be set according to an application requirement. For example, H71 is one of $\frac{1}{12}H70$, $\frac{1}{6}H70$, $\frac{1}{4}H70$, $\frac{1}{3}H70$, $\frac{5}{12}H70$, $\frac{1}{2}H70$, $\frac{7}{12}H70$, or $\frac{2}{3}H70$, or a plurality of ratios in a range of the foregoing ratios. It may be understood that, if $H71 > \frac{2}{3}H70$, the recess is excessively small, which affects overall light transmittance of the isolation member, and if an excessively small negative-pressure cavity is formed, this also affects an effect of preventing movement or inclination of the solar cell. If H71 = 0, that is, the central portion does not exist, an isolation effect and a stabilizing effect of the isolation members cannot be ensured by relying on only the peripheral portion.

In a specific embodiment, the isolation members 120 are disposed on the light receiving surface 101 of the solar cell.

In some embodiments, the isolation members 120 are disposed on the light receiving surface 101, the light receiving surface 101 has a micro pyramid structure, the minimum height H71 of the central portion 712 is a vertical distance from the lowest point of the recess 7121 to the highest point of the micro pyramid structure, and the maximum height H70 of the isolation members 120 is a vertical distance from the highest point of the isolation members 120 to the highest point of the micro pyramid structure.

In the embodiments of the present application, the minimum height H71 of the central portion 712 is the vertical distance from the lowest point of the recess 7121 to the highest point of the micro pyramid structure, and the maximum height H70 of the isolation members 120 is the vertical distance from the highest point of the isolation members 120 to the highest point of the micro pyramid structure. In this case, the isolation members 120 do not affect the foregoing beneficial effects of the micro pyramid structure, increase a light trapping effect, and improve light absorbing efficiency, to use more solar energy. In addition, the micro pyramid structure is prevented from being scuffed when a plurality of solar cells are stacked, thereby ensuring performance of the solar cells.

In some embodiments, referring to FIG. 15, a maximum size of an orthogonal projection of the isolation members 120 on the solar cell body 100a is W70, and a maximum size of an orthogonal projection of the central portion 712 on the solar cell body 100a is W71, where H70 ≤ (W70-W71)/2.

In the embodiments of the present application, when the maximum dimension W70 of the orthographic projection of the isolation members 120 on the solar cell body 100a, the maximum dimension W71 of the orthographic projection of the central portion 712 on the solar cell body 100a, and the maximum height H70 of the isolation members 120 have the foregoing proportional relationship, a connecting area between the isolation members 120 and the surface of the solar cell body 100a is large, and the isolation members 120 are stably disposed on the surface of the solar cell body 100a, and well support adjacent solar cells. In addition, when the isolation members 120 attract and fix adjacent solar cells, the isolation members 120 can well attract and fix two adjacent solar cells, thereby avoiding a situation of inclination in the process of stacking and transferring a plurality of solar cells.

It may be understood that, the relationship among the maximum size W70 of the orthographic projection of the isolation members 120 on the solar cell body 100a, the maximum size W71 of the orthographic projection of the central portion 712 on the solar cell body 100a, and the maximum height H70 of the isolation members 120 is specifically set according to an application requirement. For example, H70 is one of (W70-W71)/12, (W70-W71)/6, (W70-W71)/4, (W70-W71)/3, 5 (W70-W71)/12, and (W70-W71)/2, and a plurality of ratios in a range of the foregoing ratios. If H70 is greater than (W70-W71)/2, for a peripheral portion on one side, stability of the peripheral portion may be affected.

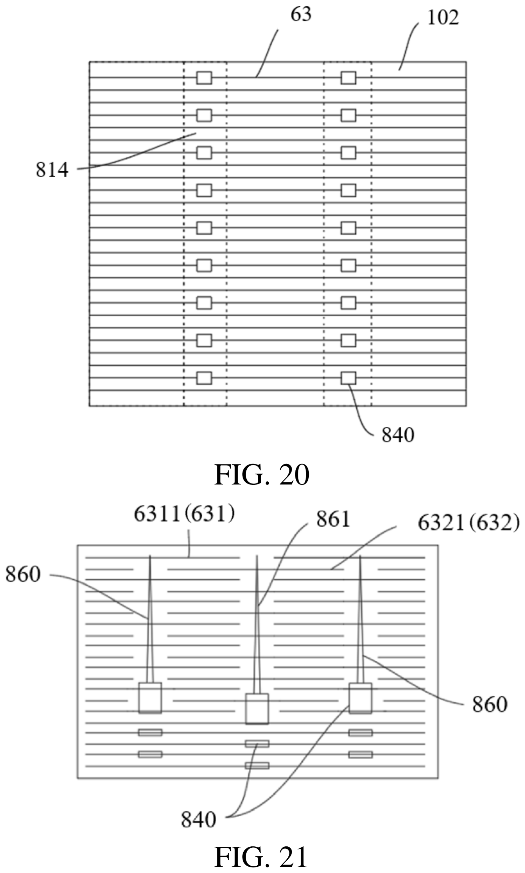

Referring to FIG. 16 and FIG. 20, the isolation members 120 further include a cover layer 7124 (a block part in FIG. 20 is the cover layer 7124), and the cover layer 7124 partially or completely covers the recess 7121. In the embodiments of the present application, the arrangement of the cover layer 7124 can prevent the packaging adhesive film 730 from filling the recess 7121 when the isolation members 120 are connected to the packaging adhesive film 730, and consequently, affecting the function of the recess 7121, thereby ensuring a light entrapment property of the isolation member 120. With reference to the foregoing embodiments, when the recess 7121 has a small projection size, effects, such as an insufficient increase in the light transmittance and a decrease in the absorption stability, caused due to the small recess are compensated by using the cover layer 7124.

In some embodiments, as shown in FIG. 16, at least one cavity 7113 is formed inside the peripheral portion 711. The arrangement of the cavity 7113 can enable incident light to be reflected for a plurality of times at the isolation members 120, lengthen a path length of light inside the photovoltaic module, and enhance the light trapping effect, to improve the light absorbing efficiency, and use more solar energy.

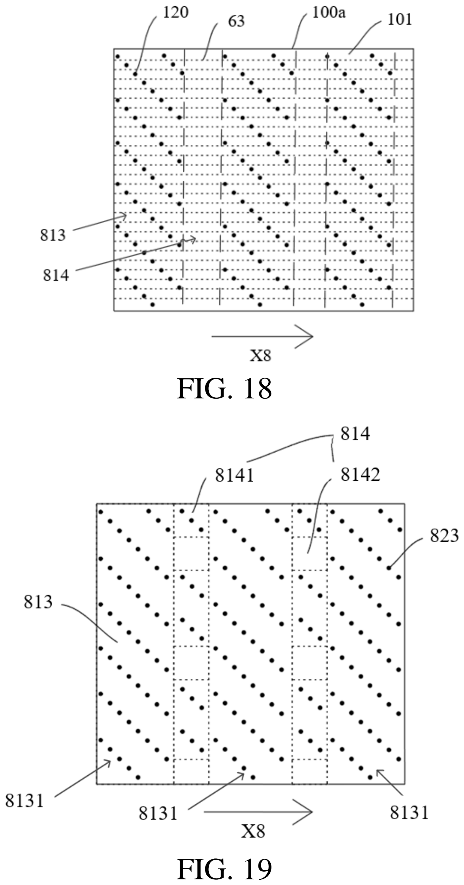

A structure of a solar cell in the seventh group of embodiments in the first aspect of the present application is described in detail in the following with reference to FIG. 18 to FIG. 22.

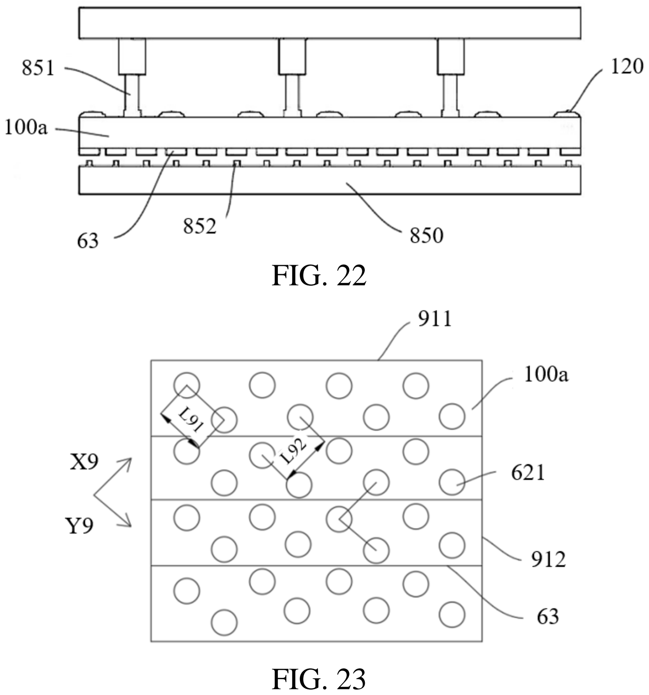

When a performance test is performed on a solar cell, in some tests, a test probe of a test apparatus is in contact with a test point such as a finger or a pad of the solar cell. For example, referring to FIG. 22, when an IV test, to be specific, a current-voltage characteristic test, is performed, a test probe 852 is in contact with a test point such as a pad. To ensure that the test probe 852 is in sufficient and effective contact with the test point, a pressing member 851 is further used to press against a surface opposite to a surface provided with fingers 63 on the solar cell. It is found that, when the isolation member 120 is manufactured, heights of the plurality of isolation members 120 may be different. In this way, if the pressing member 851 is in contact with the isolation members 120, during the test, pressures at test points on a back surface of the solar cell are different. Consequently, contact degrees between the test probe 852 and the test points on the back surface of the solar cell are different. Therefore, a test difference occurs during the test, affecting accuracy of a test result. The foregoing problems can be resolved by using the solar cell disclosed in the embodiments of the present application.

In this group of embodiments, the embodiments of the present application disclose a solar cell. Referring to FIG. 18, the solar cell includes a solar cell body 100a, a plurality of isolation members 120, and a plurality of fingers 63. The solar cell body 100a includes a light receiving surface 101 and a back surface opposite to the light receiving surface, the light receiving surface 101 includes a fifth region 813 and a plurality of sixth regions 814, and the plurality of isolation members 120 are disposed on the light receiving surface 101 of the solar cell body 100a.

In some embodiments, a density of isolation members 120 located in the fifth region 813 is greater than a density of isolation members 120 located in the sixth regions 814. The plurality of fingers 63 are disposed on the back surface 102 of the solar cell body 100a, the plurality of sixth regions 814 are arranged along an extension direction (for the extension direction, refer to an arrow X8 in FIG. 18) of the fingers 63, and an extension direction of the sixth regions 814 is perpendicular to the fingers 63.

On the light receiving surface 101, the density of the isolation members 120 located in the fifth region 813 is greater than the density of the isolation members 120 located in the sixth regions 814. The density of the isolation members 120 in the sixth regions 814 is small, and the sixth regions 814 may be used as regions in contact with the pressing member 851 when a performance test is performed on the solar cell. In this way, the pressing member 851 pressing the isolation members 120 or being in contact with the isolation members 120 can be reduced or prevented, so that forces under which the pressing member 851 presses the solar cell are balanced, and test points on the back surface 102 of the solar cell are under the same or approximately the same pressures. Therefore, contact degrees between the test probe 852 and the test points are the same, and the test probe 852 and the test points can be in sufficient and effective contact, so that accuracy of a test result of the solar cell is high.

The test points include the fingers 63, pads, and the like.

The density of the isolation members 120 refers to a coverage area of the isolation members 120 per unit area.

In some embodiments, a height of the isolation members 120 is greater than a height of electrodes. The electrode may be at least one of a finger, a busbar, an end line, or a pad. In this way, the isolation members 120 can reduce a probability that electrodes on an adjacent solar cell touches the light receiving surface 101 of the solar cell, thereby effectively reducing a probability that the electrodes on the adjacent solar cell scuffs the light receiving surface 101 of the solar cell.

Further, the height of the isolation members 120 is greater than a height of the largest one of heights of the fingers, the busbars, the end lines, and the pads. In this way, the fingers, the busbars, the end lines, and the pads cannot touch the light receiving surface 101 of the solar cell, and cannot scratch the light receiving surface 101, so that the isolation member 120 can effectively perform isolation and protection.

In some other embodiments, the height of the isolation members 120 is less than the height of at least one of the fingers 63, the busbars, the end lines, and the pads. When a plurality of solar cells are stacked, and the isolation members 120 are in contact with at least one of the fingers 63, the busbars, the end lines, and the pads of the adjacent solar cell, the isolation members 120 support between at least some electrodes of the adjacent solar cell and the light receiving surface 101 of the solar cell for an isolation function, to avoid or reduce scuffing of the light receiving surface 101.

In some embodiments, referring to FIG. 18, there is no isolation member 120 in the plurality of sixth regions 814. In this way, when the test is performed on the solar cell, the solar cell is suitable for being abutted with a plurality of pressing members 851. For example, the sixth regions 814 are suitable for being abutted with a plurality of cylindrical pressing members, suitable for being abutted with a short strip-shaped pressing member, or suitable for being abutted with a long strip-shaped pressing member. In addition, in a process in which the pressing member 851 is abutted to the sixth region 814, it is ensured that the pressing holder 851 is definitely not in contact with the isolation members 120, thereby avoiding a test difference occurring during the test due to different contact degrees between the test probe 852 and the test points on the back surface 102 of the solar cell because the pressing member 851 presses the isolation members 120 or is in contact with the isolation members 120. Therefore, it is further ensured that the solar cell according to the embodiments of the present application has an advantage of high test result accuracy.

In some embodiments, referring to FIG. 19, the sixth region 814 includes a first sub-region 8141 and a second sub-region 8142 arranged along a direction perpendicular to the fingers 63. Isolation members 120 are disposed in the first sub-region 8141, and there is no isolation member 120 in the second sub-region 8142.

In the embodiments of the present application, when the test is performed on the solar cell, the pressing member 851 presses against the second sub-region 8142, so that it can be avoided that the pressing member 851 presses the isolation members 120 or is in contact with the isolation members 120, so that forces under which the pressing member 851 presses the solar cell are balanced, and test points on the back surface 102 of the solar cell are under the same or approximately the same pressures. Therefore, contact degrees between the test probe 852 and the test points are the same, and the test probe 852 and the test points can be in sufficient and effective contact, so that the accuracy of the test result of the solar cell is high. The arrangement of the isolation members 120 on the first sub-region 8141 can improve an isolation and protecting effect, to prevent the light receiving surface 101 from being scuffed by an adjacent solar cell when a plurality of solar cells are stacked, affecting performance of the solar cell.

In some embodiments, the first sub-region 8141 and the second sub-region 8142, and in particular, the second sub-region 8142 need to be set according to an application requirement. For example, as shown in FIG. 19, perpendicular to an extension direction of the fingers 63, the first sub-region 8141 and the second sub-region 8142 are alternately arranged.

In some embodiments, referring to FIG. 19, the fifth region 813 includes a plurality of third sub-regions 8131, and the third sub-regions 8131 and sixth regions 814 are alternately arranged along the extension direction of the fingers 63. In this way, the third sub-regions 8131 and the sixth regions 814 are adjacent to each other along the extension direction of the fingers 63. The isolation members 120 disposed on the third sub-regions 8131 can prevent adjacent solar cells from scuffing the third sub-regions 8131 and the sixth regions 814 when a plurality of solar cells are stacked, affecting performance of the solar cells.

In some embodiments, referring to FIG. 20, the solar cell further includes: a plurality of columns of pads 840 arranged along the extension direction of the fingers 63, and each column of pads 840 includes a plurality of pads 840 arranged along the direction perpendicular to the fingers 63. One column of pads 840 corresponds to one sixth region 814.

When one column of pads 840 corresponds to one sixth region 814, a projection of the sixth region 814 on the second surface covers all of the column of pads 840, or covers some of the column of pads 840, for example, covers pads 840 located in the middle of the back surface 102, and pads 840 located at an edge of the back surface 102 may be uncovered.

When the performance test is performed on the solar cell, a test probe 852 of a test mechanism 850 may be in contact with the pads 840. Because the sixth regions 814 may be used as regions in contact with the pressing member 851 when the performance test is performed on the solar cell, the pressing member 851 can be used as a support when the test probe 852 performs the test. The density of the isolation members 120 in the sixth regions 814 is small, and may reduce or prevent the pressing member 851 from pressing the isolation members 120 or from being in contact with the isolation members 120. In this way, forces under which the pressing member 851 presses the solar cell are balanced, and test points on the back surface 102 of the solar cell are under the same or approximately the same pressures. Therefore, contact degrees between the test probe 852 and the test points are the same, and the test probe 852 and the test points can be in sufficient and effective contact, so that the accuracy of the test result of the solar cell is improved.

In some embodiments, the sixth region 814 includes a first sub-region 8141 and a second sub-region 8142, for example, includes a first sub-region 8141 and a second sub-region 8142 that are alternately arranged. A projection of the second sub-region 8142 on the back surface 102 covers at least one pad 840. Herein, the projection of the second sub-region 8142 on the back surface may cover one pad 840, or may cover two or more pads 840. This is not limited herein. In this way, when the pressing member 851 may be in contact with the second sub-region 8142 to press the solar cell body 100a, there is no isolation member 120 in the second sub-region 8142, in other words, there is no isolation member 120 at pads 840 corresponding to the second sub-region 8142. This further avoids impact of the isolation members 120 on contact pressure between the test probe 852 and the pads 840, and ensure that the test probe 852 is in sufficient and effective contact with the pads 840, thereby ensuring the accuracy of testing of the solar cell. In addition, the isolation members 120 located in the first sub-region 8141 may further perform an isolation and protecting function on the solar cell.

In the solar cell, one column of pads 840 may be electrically connected to all fingers 63 having a same polarity. When the performance test is performed on the solar cell, the test probe 852 may be in electrical contact with all the pads 840 in the column of pads 840.

In some embodiments, along the extension direction of the fingers 63, a width of the sixth region 814 ranges from 1 mm to 10 mm. In the embodiments of the present application, when the width of the sixth region 814 is within the foregoing range, the width of the sixth region 814 is moderate, to ensure that the pressing member 851 can be disposed in the sixth region 814, which can reduce or prevent the pressing holder 851 from pressing against the isolation members 120 or being in contact with the isolation members 120 when the performance test is performed on the solar cell, and can enable the isolation members 120 to achieve a good isolation and protection effect. In this way, while ensuring the performance of the solar cell, an accurate performance test can further be performed on the solar cell.

It may be understood that, the width of the sixth region 814 is specifically set according to an application requirement. For example, the width of the sixth region 814 is 1 mm, 2 mm, 3 mm, 4 mm, 5 mm, 6 mm, 7 mm, 8 mm, 9 mm, or 10 mm, or a plurality of values in a range between the foregoing values.

When the width of the sixth region 814 is less than 1 mm, the width of the sixth region 814 is excessively small, and when the performance test is performed on the solar cell, the pressing member 851 needs to be very precisely pressed down to be in contact with the sixth region 814, which increases operation difficulty. In addition, the pressing holder 851 may easily cover the fifth region 813, and further contact the isolation members 120 in the fifth region 813, and press the isolation members 120 or contact a part of the isolation members 120, affecting the accuracy of the performance test. When the width of the sixth region 814 is greater than 10 mm, the width of the sixth region 814 is excessively large, an area of the fifth region 813 is excessively small, and the quantity of disposed isolation members 120 is reduced. This affects an effect of protecting the light receiving surface 101 by the isolation member 120, and the light receiving surface 101 is easily scuffed by an adjacent solar cell when a plurality of solar cells are stacked.

In some embodiments, as shown in FIG. 21, the solar cell further includes a first end line 860 and a second end line 861. The plurality of fingers include first fingers 631 and second fingers 632 sequentially and alternately arranged along the direction perpendicular to the fingers. A part of the first fingers 631 located at at least one edge of the solar cell body include a plurality of segments of first sub-fingers 6311 arranged at intervals, and a part of the second fingers 632 include a plurality of segments of second sub-fingers 6321 arranged at intervals. The first sub-fingers 6311 and the second sub-fingers 6321 are arranged in a staggered manner. A plurality of first sub-fingers 6311 arranged along the direction perpendicular to the fingers are electrically connected together by using the first end line 860, and a plurality of second sub-fingers 6321 arranged along the direction perpendicular to the fingers are electrically connected together by using the second end line 861. The first end line 860 and the second end line 861 respectively correspond to the sixth regions.

That the first end line 860 and the second end line 861 respectively correspond to the sixth region means that the first end line 860 or the second end line 861 is formed in a projection coverage area of one sixth region or an area in an extension direction of one sixth region on the back surface 102.

Because the first end line 860 electrically connects the plurality of first sub-fingers 6311 together, and the second end line 861 electrically connects the plurality of second sub-fingers 6321 together, pads do not need to be disposed on each finger 63, and only a small quantity, for example, one pad, needs to be disposed on the first end line 860 and the second end line 861. During performance test, the test probe 852 only needs to be in contact with the pad on the first end line 860 and the second end line 861, thereby reducing the quantity of pads. A position on the light receiving surface 101 not corresponding to a pad does not need to correspond to the pressing member 851, so that isolation members 120 may be disposed, to increase a quantity of the isolation members 120, thereby improving an anti-scratch effect.

In some embodiments, an extension direction of the isolation members 120 is parallel to or intersected with the extension direction of the fingers 63. When the extension direction of the isolation members 120 is intersected with the extension direction of the fingers 63, an included angle may be an acute angle, or may be a right angle. The isolation members 120 can have a good isolation and protecting function.

In an embodiment, for a range of the height h of the isolation members 120, refer to the foregoing embodiments.

A structure of a solar cell in the eighth group of embodiments in the first aspect of the present application is described in detail in the following with reference to FIG. 1 and FIG. 23 to FIG. 25.

It is considered that when a distance between isolation bumps is excessively small, for example, when two adjacent isolation bumps are close to each other, material costs of the isolation bumps are increased; and when the distance between the isolation bumps is excessively large, an isolation effect of the isolation bumps is poor. Therefore, it is difficult to balance between the isolation effect and the material costs of the isolation bumps in arrangement of the isolation bumps. Referring to FIG. 23 to FIG. 25, the embodiments of this application provide a solar cell, to resolve the foregoing existing technical problems.

In this group of embodiments, the isolation members include isolation bumps 621. In a direction of the thickness of a solar cell body, the solar cell body includes a first surface and a second surface that are oppositely disposed, and the isolation bumps 621 are disposed on the first surface and/or the second surface of the solar cell body.

In some embodiments, referring to FIG. 23, a plurality of isolation bumps 621 are arranged in a plurality of rows along a fourth direction X9, each of the plurality of rows of isolation bumps 621 includes a plurality of isolation bumps 621 arranged along a fifth direction Y9, and during design, the plurality of isolation bumps 621 satisfy the following relationship:

$$0 < l < \sqrt[4]{3 * 10^5 mm^3 * \frac{hn}{N0.098}}$$ , where $l$ is a larger one of a distance between two adjacent isolation bumps 621 along the fourth direction X9 and a distance between two adjacent isolation bumps 621 along the fifth direction Y9, h is a height of the isolation bumps 621, and n is rounding of a ratio of a long side to a short side of the solar cell. It should be noted that, the rounding of the ratio of the long side to the short side means that when a decimal part of the ratio after rounding is greater than or equal to 0.5, ceiling may be performed; when the decimal part of the ratio after rounding is less than 0.5, flooring may be performed, and N is a quantity of solar cells when stacked.

In the embodiments of the present application, referring to FIG. 23, the distance between two adjacent isolation bumps 621 along the fourth direction X9 is L92, and the distance between two adjacent isolation bumps 621 along the fifth direction Y9 is L91. Comparing L92 and L91, a larger one of L91 and L92 is a maximum distance $l$ between adjacent isolation bumps 621 along the fourth direction X9 or along the fifth direction Y9.

It should be noted that, the "distance $l$ between two adjacent isolation bumps 621" below refer to a larger one of the distance between two adjacent isolation bumps 621 along the fourth direction X9 and the distance between two adjacent isolation bumps 621 along the fifth direction Y9. When the light receiving surface of the solar cell body 100a is a polished surface, along a thickness direction of the solar cell body 100a, a distance between an end of the isolation bumps 621 facing away from the solar cell body 100a to an interface at which the isolation bumps 621 are in contact with the solar cell body 100a is the height h of the isolation bumps 621. When the light receiving surface of the solar cell body 100a is a pyramid textured surface, along a thickness direction of the solar cell body 100a, a distance between an end of the isolation bumps 621 facing away from the solar cell body 100a and the top of the pyramid in an interface at which the isolation bumps 621 are in contact with the solar cell body 100a is the height h of the isolation bumps 621.

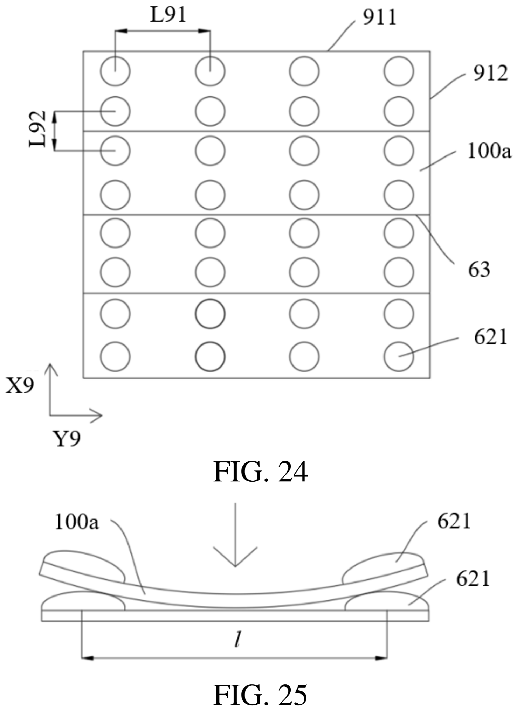

Referring to FIG. 24, in some examples, the solar cell body 100a has two oppositely disposed first surfaces 911 and two oppositely disposed second surfaces 912. The first surfaces 911 are perpendicular to the second surfaces 912. A length of the first surfaces 911 is a1, and a length of the second surfaces 912 is b1. Comparing the length of the first surfaces 911 and the length of the second surfaces 912, if al > b1, n is rounding of a1/b1; if a1 and b1 are equal or approximately equal, n is 1.

When a plurality of solar cells are stacked, solar cells other than a solar cell at the top layer are all bent under pressure of other solar cells. Referring to FIG. 25, a higher height of the isolation bumps 621 indicates that it is more difficult for fingers 63, busbars, pads 840, end lines, and the like of a solar cell at an upper layer to be in contact with a light receiving surface of a solar cell at a lower layer, and further, it is more difficult for the solar cell at the upper layer to scratch the light receiving surface of the solar cell at the lower layer. The distance between adjacent isolation bumps 621 affects a curvature degree of the solar cell, and a larger distance between adjacent isolation bumps 621 indicates a larger curvature degree of the solar cell, and a larger curvature degree indicates that it is easier to scratch a light receiving surface of a solar cell adjacent to the solar cell. In addition, a weight of the solar cell may also affect the pressure generated by the solar cell. When a weight of an entire solar cell is fixed, a larger quantity of slices of the entire solar cell indicates a smaller weight of a sliced solar cell, and less pressure is generated. It may be understood that, n is rounding of the ratio of the long side to the short side of the solar cell. When n is 1, the solar cell is the entire solar cell, and is not sliced; when n is 2, the solar cell is divided into two slices, and when n is 3, the solar cell is divided into three slices, and so on. Details are not described herein again. Because a weight change of the entire solar cell can be ignored, the weight of the solar cell may be represented by using a quantity of slices of the entire solar cell, that is, the rounding n of the ratio of the long side to the short side of the solar cell. Based on the foregoing descriptions, it can be seen that, when the isolation bumps 621 are designed, the height of the isolation bumps 621, the distance between two adjacent isolation bumps 621, the weight (that is, the rounding n of the ratio of the long side to the short side of the solar cell) of the solar cell, and the like need to be considered. In this way, the isolation bumps 621 can better avoid a risk of scratch on the light receiving surface of the solar cell.

During design of the solar cell in the embodiments of the present application, by making $l$, h, and n satisfy a relationship: $0 < l < \sqrt[4]{3 * 10^5 mm^3 * \dfrac{hn}{N0.098}}$ , the height h of the isolation bumps 621 and the distance between two adjacent isolation bumps 621 are both set properly. This can effectively avoid a case in which when a plurality of solar cells are stacked, a solar cell is bent under pressure and scratches a light receiving surface of an adjacent solar cell, thereby avoiding affecting beauty and efficiency of the solar cells. In addition, this can also avoid increases in material costs and in processing difficulty of manufacturing the isolation bumps because the distance l between two adjacent isolation bumps 621 is set to be Z small, and avoid a poor isolation effect because the distance between two adjacent isolation bumps 621 is set to be large. The solar cell in the embodiments of the present application have advantages such as a good isolation effect, low material costs, and low processing difficulty.

In some embodiments, when N is 2, l, h, and n satisfy a relationship:

$$0 < l < \sqrt[4]{15.3 * 10^5 mm^3 * hn}$$ .

In the embodiments of the present application, the solar cells are naturally aligned by gravity in a stacking process. A limit case of stacking a plurality of solar cells is that two solar cells are stacked, that is, N ≥ 2. When N ≥ 2, and l, h, and n satisfy the foregoing relationship, the height h of the isolation bumps 621 and the distance l between two adjacent isolation bumps 621 are both set properly. This can effectively avoid a case in which when at least two solar cells are stacked, a solar cell at the upper layer is bent under pressure and scratches a light receiving surface of a solar cell at the lower layer.

It should be noted that when being stacked and transferred, the solar cells may be stacked and transferred in a form of an entire solar cell, or may be stacked and transferred in a form of sliced solar cells such as two slices, three slices, or four slices.

In some embodiments, when the solar cell is a back contact solar cell, the first surface is the light receiving surface of the solar cell, and the second surface is the back surface of the solar cell. The isolation bumps 621 are disposed on at least one of the first surface and the second surface.

In some embodiments, when n is 1, that is, when the solar cell is an entire solar cell, l, h, and n satisfy a relationship: $0 < l < \sqrt[4]{15.3 * 10^5 mm^3 * h}$ .

In the embodiments of the present application, the solar cells are stacked and transferred in a form of the entire solar cell. A length of a first side 911 is a1, a length of a second side 912 is b1, and a1 > b1. If a1 and b1 are equal or approximately equal, n is 1. When and h satisfy the foregoing relationship, proper l may be obtained by considering the height h of the isolation bumps 621. The height h of the isolation bumps 621 and the distance l between two adjacent isolation bumps 621 are both set properly, so that this can effectively prevent a solar cell from being bent under pressure and scratching a light receiving surface of an adjacent solar cell when two or more solar cells are stacked.

In some embodiments, when n is 2, that is, when the solar cell is a half-sliced solar cell, l and h satisfy a relationship: $0 < l < \sqrt[4]{30.6 * 10^5 mm^3 * h}$ .

When the solar cells in the embodiments of the present application are stacked and transferred in a form of the half-sliced solar cell, a length of the first side 911 is a2, a length of the second side 912 is b2, and a2 < b2. n is rounding of b2/a2, and n is 2. When l and h satisfies the formula $0 < l < \sqrt[4]{30.6 * 10^5 mm^3 * h}$ , the height h of the isolation bumps 621 and the distance l between two adjacent isolation bumps 621 can be comprehensively considered, so that the height h of the isolation bumps 621 and the distance l between two adjacent isolation bumps 621 are set properly. This can effectively avoid a case in which when two or more half-sliced solar cells are stacked, a half-sliced solar cell is bent under pressure and scratches a light receiving surface of an adjacent half-sliced solar cell.

In some other embodiments, when n is 3, that is, when the solar cell is a one-third sliced solar cell, l and h satisfy a relationship: $0 < l < \sqrt[4]{45.9 * 10^5 mm^3 * h}$ .

When the solar cells in the embodiments of the present application are stacked and transferred in a form of the one-third sliced solar cell, comparing a length a3 of the first side 911 with a length b3 of the second side 912, a3 < b3, n is rounding of b3/a3, and n is 3. When l and h satisfy the relationship: $0 < l < \sqrt[4]{45.9 * 10^5 mm^3 * h}$ , the height h of the isolation bumps 621 and the distance l between two adjacent isolation bumps 621 can be comprehensively considered, so that the height h of the isolation bumps 621 and the distance l between two adjacent isolation bumps 621 are set properly, and when two or more of one-third sliced solar cells are stacked, a one-third sliced solar cell can be effectively prevented from being bent and scratching a light receiving surface of an adjacent one-third sliced solar cell.

Based on the formula $0 < l < \sqrt[4]{3 * 10^5 mm^3 * \dfrac{hn}{N0.098}}$ , it can be known that when a plurality of solar cells are stacked, a larger quantity of the stacked solar cells indicates a smaller distance $l$ between two adjacent isolation bumps 621 that needs to be set.

When a plurality of solar cells are stacked, the quantity of stacked solar cells may be selected according to a requirement. In some examples, a value range of N may be $2 \le N \le 1000$. For example, N may be one of 2, 3, 4, 10, 50, 100, 150, 200, 300, 400, 500, 600, 700, 800, 900, or 1000, or a plurality of values between the foregoing values. When N > 1000, there is an excessively large quantity of stacked solar cells, and a pressure on a solar cell at the bottom layer may be increased, which may cause breakage or even fragmentation, and a total weight and a total volume of the stacked solar cell are large, increasing handling difficulty and risks. In addition, alignment difficulty of the solar cell increases.

In some embodiments, $2 \le N \le 200$. In this way, the quantity of the stacked solar cells is proper, so that a transport requirement can be satisfied, and a damage risk can be reduced.

In some embodiments, when the quantity N of the stacked solar cells $\ge$ 150, it may be designed that $l$, h, and n satisfy a relationship: $0 < l < \sqrt[4]{0.204 * 10^5 mm^3 * hn}$ .

In the embodiments of the present application, when the quantity N of the stacked solar cells $\ge$ 150, the distance $l$ between two adjacent isolation bumps 621 is designed within the range of $0 < l < \sqrt[4]{0.204 * 10^5 mm^3 * hn}$ . When at least 150 solar cells are stacked, a solar cell can still be prevented from being bent under pressure and scratching a light receiving surface of an adjacent solar cell, and the height h of the isolation bumps 621 and the distance $l$ between two adjacent isolation bumps 621 are both set properly, to avoid a poor isolation effect caused by the distance $l$ between two adjacent isolation bumps 621 being set to be large.

In some embodiments, n is 1, that is, when the solar cell is an entire solar cell, $l$, h, and n satisfy a relationship: $0 < l < \sqrt[4]{0.204 * 10^5 mm^3 * h}$ . In this way, the height h of the isolation bumps 621 and the distance $l$ between two adjacent isolation bumps 621 are both set properly, and the isolation bumps 621 can avoid scratch on the light receiving surface of the solar cell.

In some embodiments, when n is 2, that is, when the solar cell is a half-sliced solar cell, $0 < l < \sqrt[4]{0.408 * 10^5 mm^3 * h}$ . For effects when is within the range, refer to the foregoing descriptions. Details are not described herein again.

In some other embodiments, when n is 3, that is, when the solar cell is a one-third sliced solar cell, $l$ and h satisfy a relationship: $0 < l < \sqrt[4]{0.612 * 10^5 mm^3 * h}$ . For effects when $l$ is within the range, refer to the foregoing descriptions. Details are not described herein again.

In some embodiments, a maximum size of a projection of a respective isolation bump of the plurality of isolation bumps 621 on the solar cell body 100a is d, satisfying d < $l$. In this way, it can be avoided that two adjacent isolation bumps 621 along the fourth direction X9 are connected, and two adjacent isolation bumps 621 along the fifth direction Y9 are connected, so that material costs of the isolation bumps 621 are reduced, and difficulty in a process of manufacturing the plurality of isolation bumps 621 can also be reduced.

In some embodiments, a specific shape of the isolation bumps 621 is set according to an application requirement. For example, a projection of the isolation bumps 621 on the solar cell body 100a is at least one of a circle and a polygon. In addition, when the projection of the isolation bump 621 on the solar cell body 100a is a circle, d refers to a diameter.

It is considered that if the maximum size of the projection of the isolation bumps 621 on the solar cell body 100a is excessively small, it is difficult to manufacture the isolation bumps; if the maximum size of the projection of the isolation bumps 621 on the solar cell body 100a is excessively large, it affects light absorption of the solar cell. Therefore, in some embodiments, $0.05 \text{ mm} \le d \le 2 \text{ mm}$.

When d < $l$, and d is within the foregoing range, when designing the isolation bumps 621, $l$ may be greater than 2 mm, $l$ may be greater than 0.05 mm, or $l$ may be greater than any value between 0.05 mm and 2 mm. When $l$ is greater than 2 mm, a lower limit of $l$ is high. In this case, on the basis of ensuring anti-scratch, a quantity of the isolation bumps 621 may be reduced, to reduce material costs and processing costs of the isolation bumps 621. When $l$ is greater than 0.05 mm, a lower limit of $l$ is small. In this case, $l$ may be set to a small value, to expand a range from which $l$ can be selected, and a quantity of the isolation bumps 621 may also be set large, to improve an isolation and protection effect and avoid scuffing on the light receiving surface of the solar cell.

It may be understood that, d may be set according to an application requirement, and this is not specifically limited in the embodiments of the present application. For example, d is one of 0.05 mm, 0.06 mm, 0.07 mm, 0.08 mm, 0.09 mm, 0.1 mm, 0.2 mm, 0.3 mm, 0.5 mm, 0.7 mm, 1 mm, 1.2 mm, 1.4 mm, 1.6 mm, 1.8 mm, or 2 mm, or a plurality of values between the foregoing values.

In some embodiments, for the height h of the isolation bumps 621, refer to the foregoing embodiments.

In some embodiments, when n is 1, and the solar cell is an entire solar cell, $l$ satisfies: $0.05 \text{ mm} < l \le 18.7 \text{ mm}$. Alternatively, when n is 2, and the solar cell is a half-sliced solar cell, $l$ satisfies: $0.05 \text{ mm} < l \le 22.2 \text{ mm}$. Alternatively, when n is 3, and the solar cell is a one-third sliced solar cell, $l$ satisfies: $0.05 \text{ mm} < l \le 24.6 \text{ mm}$.

In some embodiments, the solar cell body 100a has two oppositely disposed first sides 911 and two oppositely disposed second sides 912, the first sides 911 are perpendicular to the second sides 912, the fourth direction X9 is parallel to the first sides 911, and the fifth direction Y9 is parallel to the second sides 912; or the fourth direction X9 and the fifth direction Y9 form an acute angle with the first sides 911 and the second sides 912. In this way, the arrangement of the isolation bumps 621 is regular. Compared with random arrangement of the isolation bumps 621, an extension direction of the isolation bumps 621 is intersected with the first sides 911, and an included angle is an acute angle, so that the surface of the solar cell body 100a can be better completely protected.

In some other embodiments, as shown in FIG. 24, the fifth direction Y9 is parallel to the first sides 911, that is, an extension direction of each of the plurality of rows of isolation bumps 621 is parallel to the first sides 911.

It should be noted that, the specific features, structures, materials, or characteristics described in embodiments in the first aspect of the foregoing specification may be combined in a proper manner in any one or more of the embodiments or examples. These combinations also fall within the protection scope of the present application.

According to a second aspect, the present application further provides a photovoltaic module, including the solar cell according to the foregoing descriptions.

The following describes the photovoltaic module according to the second aspect of the present application in detail.

The photovoltaic module provided in the embodiments of the present application includes the solar cell according to any one of the foregoing embodiments. The photovoltaic module has technical effects same as those of the solar cell provided in the foregoing embodiments. Refer to the foregoing descriptions.

According to the photovoltaic module in the embodiments of the present application, the isolation members are disposed on the surface of the solar cell, improve physical strength of the solar cell. In this way, in a transferring process before laminating, a plurality of solar cells are stacked, and the isolation members enable a gap between surfaces of two adjacent solar cells, so that the two adjacent solar cells do not contact each other to cause a surface scratch on the solar cell, thereby avoiding affecting performance of the solar cell due to the scratch. In addition, in the laminating process, the isolation members can also have a cushioning effect, to reduce stress born by the solar cell in the laminating process, improve a capability of anti-bending and anti-cracking while keeping physical strength of the solar cell without damage, and reduce a risk of cracking of the solar cell under laminating, thereby improving appearance quality of the photovoltaic module made by using the solar cell and ensuring efficiency of the photovoltaic module. In addition, the isolation members can improve a light trapping ability, thereby improving the conversion efficiency of the photovoltaic module.

In an embodiment, the photovoltaic module further includes a plurality of solar cell strings, each solar cell string includes a plurality of solar cells and a plurality of interconnection members, and the interconnection members are configured to connect the plurality of solar cells in series.

In an embodiment, the interconnection member may be a soldering tape, a metal wire, a conductive tape, or the like.

In an embodiment, the photovoltaic module further includes a cover, a back sheet, and a packaging adhesive film. The solar cell is packaged between the cover and the back sheet by the packaging adhesive film, and the isolation member is at least partially cross-linked to the packaging adhesive film after the laminating process.

The isolation members are at least partially cross-linked to the packaging adhesive film after the laminating process. In other words, the packaging adhesive film 730 and the isolation members 120 are completely not fused or are partially fused.

It may be understood that, in the photovoltaic module, packaging adhesive films are usually disposed on two sides of the solar cell, and a material for preparing the isolation members may be set to be the same as or similar to a material of the packaging adhesive films, so that the isolation members can be directly laminated into the interior of the photovoltaic module and has a small impact on light absorption of the solar cell.

In some embodiments, the cover and the back sheet may be at least understood as glasses. Generally, a conventional laminating process is performed on the photovoltaic module. In the solar cell during the laminating process, the isolation members are fused by heat and are cross-linked to a component encapsulating adhesive film, and the isolation members become a part of the packaging adhesive film. Therefore, the isolation members do not need to be removed during a production process of the photovoltaic module, thereby simplifying a laminating operation process, and helping improve laminating efficiency.

An example of the photovoltaic module according to the embodiments of the present application is described in detail with reference to FIG. 17.

In this example, peeling strength between the isolation members 120 and the solar cell 100 is greater than peeling strength between the isolation members 120 and the packaging adhesive film 730.

The peeling strength between the isolation members 120 and the solar cell 100 is greater than the peeling strength between the isolation members 120 and the packaging adhesive film 730, so that the solar cell 100 and the isolation members 120 can always remain integral. During the laminating process, the isolation members 120 do not deviate, thereby avoiding damage to the solar cell 100, and reducing a cracking risk. In addition, the isolation members 120 increase a contact structure between the solar cell 100 and the packaging adhesive film 730, form an adhesive coverage situation of point-surface contact, and reduce a direct stress on the solar cell 100 during the laminating process, thereby avoiding cracking of the solar cell 100, also improving component stability, and reducing a cracking risk of the solar cell 100 caused by an inertial offset in a transferring process of the solar cell.

The peeling strength refers to a maximum force required to peel materials adhered together from a contact surface per unit width, and reflects adhesive strength of the material. In the embodiments of the present application, the peeling strength is adhesive strength between the solar cell 100 and the packaging adhesive film 730, between the packaging adhesive film 730 and the back sheet 52, between the packaging adhesive film 730 and the cover 51, between the solar cell 100 and the isolation members 120, between the isolation members 120 and the packaging adhesive film 730, and the like. The peeling strength is related to endurance and performance of the photovoltaic module in various environmental conditions.

In the current technology, there is a plurality of test manners for the peeling strength. It may be understood that, how to measure the peeling strength is not specifically limited in the embodiments of the present application. For example, the peeling strength is measured by using a dedicated test apparatus such as a peeling strength tester. For another example, the peeling strength is measured by using a tensimeter by manually peeling the packaging adhesive film 730 and the solar cell 100 away from each other.

In some embodiments, the peeling strength between the packaging adhesive film 730 and the solar cell 100 is greater than the peeling strength between the packaging adhesive film 730 and the cover 51, and/or the peeling strength between the packaging adhesive film 730 and the solar cell 100 is greater than the peeling strength between the packaging adhesive film 730 and the back sheet 52.

According to the photovoltaic module in the embodiments of the present application, the adhesive strength between the packaging adhesive film 730 and the solar cell 100 is higher, and the adhesion between the packaging adhesive film 730 and the solar cell 100 is firmer. Even if the photovoltaic module is used for long time under the action of gravity, or is vibrated or shaken, delayering does not easily occur, thereby reducing a risk of delayering, and further prolonging a service life of the photovoltaic module.

The isolation members 120 disposed on the solar cell 100 can form a plurality of adhesive points, so that the packaging adhesive film 730 is more firmly adhered to the solar cell 100 by using the plurality of adhesive points, to form a coverage situation of point-surface contact on the packaging adhesive film 730. In this way, a coverage area of the packaging adhesive film 730 is larger, the adhesive flow is smoother in the laminating process, and the edge of the packaging adhesive film 730 does not easily warp, thereby reducing a height difference or a stair between the edge of the solar cell 100 and the packaging adhesive film 730. Because of the isolation members 120, the packaging adhesive film 730 in contact with the solar cell 100 has low stiffness, to reduce pressure born by the solar cell 100 in the laminating process, and reduce a cracking risk of the solar cell 100.

In the foregoing structure of the embodiments of the present application, the peeling strength between the packaging adhesive film 730 and the solar cell 100 is greater than the peeling strength between the packaging adhesive film 730 and the cover 51; or the peeling strength between the packaging adhesive film 730 and the solar cell 100 is greater than the peeling strength between the packaging adhesive film 730 and the back sheet 52; or the peeling strength between the packaging adhesive film 730 and the solar cell 100 is greater than the peeling strength between the packaging adhesive film 730 and the cover 51, and is greater than the peeling strength between the packaging adhesive film 730 and the back sheet 52. Therefore, strong adhesion between the packaging adhesive film 730 and the solar cell 100 can achieve sealing and waterproofing effects on the solar cell 100, and improve photoelectric conversion stability.

In an embodiment, as shown in FIG. 2, the photovoltaic module further includes an adhesive film layer 140. A surface of the solar cell body 100a provided with isolation bumps 230 is a first surface, the first surface is provided with the adhesive film layer 140. The adhesive film layer 140 covers the isolation bumps 230, and a refractive index of the adhesive film layer 140 is less than a refractive index of the isolation bumps 230.

In the embodiments of the present application, the adhesive film layer 140 is disposed on the surface of the solar cell body 100a provided with the isolation bumps 230, so that the adhesive film layer 140 covers the isolation bumps 230, and the isolation bumps 230 are embedded in the adhesive film layer 140. Incident light is irradiated into the solar cell body 100a after sequentially passing through the adhesive film layer 140 and the isolation bumps 230. Further, by setting refractive indexes of the adhesive film layer 140, the isolation bumps 230, and the solar cell body 100a to sequentially increase, it is convenient to form a light trapping effect at interfaces of different refractive indexes, so as to improve a light absorption rate of the solar cell, thereby improving conversion efficiency of the photovoltaic module.

In some embodiments, the adhesive film layer 140 may be made of a transparent material such as POE or EVA, to package and protect the solar cell. A light transmittance of the adhesive film layer 140 is greater than or equal to 90%. For example, the light transmittance of the adhesive film layer 140 may be set to any value such as 90%, 92%, 93%, 95%, or 98%.

In an embodiment, the refractive index of the adhesive film layer 140 ranges from 1.4 to 1.5.

In the embodiments of the present application, a range of the refractive index of the adhesive film layer 140 is set, to ensure that the refractive index of the adhesive film layer 140 is less than the refractive index of the isolation bumps 230, so that a light trapping effect is formed between the adhesive film layer 140 and the isolation bump 230, thereby improving the conversion efficiency of the photovoltaic module.

For example, the refractive index of the adhesive film layer 140 may be set to any value such as 1.4, 1.42, 1.45, 1.47, 1.48, or 1.5, or a range between any two values.

In an embodiment, the adhesive film layer 140 includes a plurality of sequentially stacked film sub-layers, and refractive indexes of the plurality of film sub-layers decrease from the first surface to a direction away from the solar cell body 100a.

In the embodiments of the present application, the adhesive film layer 140 is disposed to include the plurality of sequentially stacked film sub-layers, and the refractive indexes of the plurality of film sub-layers are made to decrease along the direction away from the solar cell body 100a. In this way, it is beneficial for light to pass through the adhesive film layer 140 and enter the interior of the photovoltaic module, and reflection of the light at different interfaces is reduced, to improve the light absorption rate of the solar cell and improve the conversion efficiency of the photovoltaic module.

For example, the plurality of film sub-layers may be made of different materials, provided that it is ensured that the refractive index of each film sub-layer tends to decrease in the direction away from the solar cell body 100a. This is not limited in the embodiments of the present application.

In an embodiment, as shown in FIG. 2, along a direction perpendicular to the first surface, a ratio H51/H6 of a height H51 of the isolation bump 230 to a height H6 of the adhesive film layer 140 is 20% to 45%.

It may be understood that, during actual application, generally, a solar cell is first prepared, and then a photovoltaic module is prepared from the solar cell. If a difference between the heights of the adhesive film layer 140 and the isolation bump 230 is excessively small, in other words, when the photovoltaic module is prepared from the solar cell, the adhesive film layer 140 covering the solar cell is excessively thin, the adhesive film layer 140 cannot achieve an effective deformation cushion function during laminating, which easily causes the solar cell to be cracked. However, if the difference between the heights of the adhesive film layer 140 and the isolation bump 230 is excessively large, in other words, the adhesive film layer 140 covered on the solar cell is excessively thick, light transmission is affected, and production costs of the adhesive film layer 140 are increased.

Therefore, a proper value range of a height ratio of the isolation bump 230 to the adhesive film layer 140 is set in the embodiments of the present application, so that during processing, the adhesive film layer 140 can be used to effectively cushion and protect the solar cell, and the production costs can also be considered. In addition, a good light trapping effect can also be formed between the adhesive film layer 140 and the isolation bump 230.

For example, a ratio H51/H6 of a height of the isolation bump 230 to a height of the adhesive film layer 140 may be set to any value such as 20%, 22%, 25%, 28%, 30%, 35%, 40%, 43%, or 45%, or a range between any two values.

In an embodiment, along the direction perpendicular to the first surface, the height of the isolation bump 230 in the photovoltaic module is 2 $\mu$m to 80 $\mu$m. In some examples, the height of the isolation bump 230 in the photovoltaic module is 2 $\mu$m to 37 $\mu$m.

For example, the height of the isolation bump 230 in the photovoltaic module may be set to any value such as 2 $\mu$m, 5 $\mu$m, 8 $\mu$m, 10 $\mu$m, 15 $\mu$m, 20 $\mu$m, 25 $\mu$m, 30 $\mu$m, 35 $\mu$m, 37 $\mu$m, 50 $\mu$m, 60 $\mu$m, 70 $\mu$m, or 80 $\mu$m, or a range between any two values.

In an embodiment, along the direction perpendicular to the first surface, the height of the adhesive film layer 140 is 35 $\mu$m to 45 $\mu$m.

For example, the height of the adhesive film layer 140 may be set to any value such as 35 $\mu$m, 36 $\mu$m, 38 $\mu$m, 40 $\mu$m, 41 $\mu$m, 43 $\mu$m, or 45 $\mu$m, or a range between any two values. In some examples, the height of the adhesive film layer 140 is 35 $\mu$m to 45 $\mu$m.

In the embodiments of the present application, by setting the height H51 of the isolation bump 230 and the height H6 of the adhesive film layer 140 in the photovoltaic module to be in proper value ranges, effective protection for the solar cell can be achieved, and the light absorption rate of the solar cell can be improved.

It should be noted that, the height H51 of the isolation bumps 230 on the surface of the solar cell body 100a in the photovoltaic module may be equal to or not equal to the height H5 of the isolation bumps 230 on the surface of the solar cell body 100a in the solar cell. Because in a process of preparing the photovoltaic module from the solar cell, the solar cell needs to be laminated, the height of the isolation bumps 230 on the surface of the solar cell body 100a varies. In some examples, the height of the isolation bumps 230 may decrease after the laminating process, that is, the height H51 is lower than the height H5.

According to a third aspect, the present application further provides a solar cell stacked structure, including a plurality of the foregoing solar cells that are stacked. The following describes the solar cell stacked structure according to the third aspect of the present application in detail.

The solar cell stacked structure in the embodiments of the present application includes a plurality of sequentially stacked solar cells. Each of the plurality of solar cells is the solar cell according to any one of the foregoing embodiments. Each of the plurality of solar cells includes electrodes, and the electrodes are disposed on a back surface of a solar cell body.

The solar cell stacked structure may also be referred to as a stacked structure of solar cells, and the stacked structure includes a plurality of solar cells. The solar cell includes electrodes 110, and the electrodes 110 are disposed on a back surface of a solar cell body 100a. An isolation member may be the isolation member according to any one of the foregoing embodiments.

In some examples, an arrangement direction of electrodes 110 on one of the solar cells is intersected with an arrangement direction of electrodes 110 on another solar cell. Certainly, an arrangement direction of electrodes 110 on one of the solar cells may alternatively be parallel to an arrangement direction of electrodes 110 on another solar cell.

According to the stacked structure of solar cells in the embodiments of the present application, the solar cells are back contact solar cells. The solar cell includes a solar cell body 100a, isolation members, and electrodes 110. The isolation members are disposed on a light receiving surface of the solar cell body 100a, the electrodes 110 are disposed on a back surface of the solar cell body 100a, and an isolating adhesive is disposed on the back surface of the solar cell body 100a and at least partially covers the electrodes 110.

In some other embodiments, referring to FIG. 8, the solar cell stacked structure includes a plurality of solar cells 100 that are stacked. Electrodes 110 are disposed on a back surface of the solar cell 100. At least a part of the solar cell stacked structure is formed by a plurality of groups of solar cells, and each of the plurality of groups of solar cells includes two solar cells 100 whose back surfaces are in contact with each other. For two adjacent solar cells 100 whose light receiving surfaces are in contact with each other in the solar cell stacked structure, a protective adhesive layer 300 is disposed on a light receiving surface of at least one of the solar cells 100, and the protective adhesive layer is the foregoing isolation member. FIG. 8 shows a solution in which the protective adhesive layer 300 is disposed on the solar cell 100.

In the embodiments of the present application, a solar cell 100 on which electrodes 110 are disposed only on a back surface is a back contact solar cell.

Specifically, referring to FIG. 8, in a solar cell stacked structure formed by stacking a plurality of stacked solar cells 100, how to ensure, by using a low-cost measure, that two surfaces of the solar cells are not scuffed is an important direction of current research. To resolve the problem, in the embodiments of the present application, at least a part of the solar cell stacked structure (at least a part of the solar cell stacked structure includes an even number of solar cells, and the entire solar cell stacked structure is shown in FIG. 8) may be formed by a plurality of groups of solar cells W, each of the plurality of groups of solar cells W is formed by two solar cells 100 whose back surfaces are in contact with each other, and the plurality of groups of solar cells W are stacked to form the solar cell stacked structure. In such a stacking manner, surfaces in the stacked structure are in contact with each other, including contact between a back surface of a solar cell in each of the plurality of groups of solar cells W and a back surface of the other solar cell, and contact between a light receiving surface of a solar cell between each group of adjacent solar cells W and a light receiving surface of the other solar cell.

Because there are electrodes 110 on the back surface of the solar cell 100, for contact between the back surface of the solar cell 100 and the back surface of the solar cell 100, electrodes 110 respectively on the two solar cells 100 may be in contact with each other and form support, so that the surface of the back surface of the solar cell 100 is not scuffed due to contact with another structure, thereby protecting the back surface of the solar cell 100.

For contact between the light receiving surface of the solar cell 100 and the light receiving surface of the solar cell 100, to avoid surface scuffing caused by direct contact between the light receiving surfaces of the two solar cells 100, in the embodiments of the present application, a protective adhesive layer 300 may be disposed on the light receiving surface of at least one of the two solar cells 100 whose light receiving surfaces are in contact with each other, so that the light receiving surfaces of the two solar cells 100 are not in direct contact. The light receiving surfaces of the two solar cells 100 can be supported and cushioned by using the protective adhesive layer 300, thereby protecting the light receiving surface of the solar cell 100. In addition, the protective adhesive layer is fixed on the light receiving surface of the solar cell, so that the protective adhesive layer does not easily fall off or cause a position deviation. Therefore, the protective adhesive layer can continuously protect the light receiving surface of the solar cell.

In an embodiment, for two adjacent solar cells 100 whose light receiving surfaces are in contact with each other in the solar cell stacked structure, a protective adhesive layer 300 is disposed on a light receiving surface of one of the solar cells 100. Because the protective adhesive layer is disposed on only the light receiving surface of at least one of the two adjacent solar cells whose light receiving surfaces are in contact with each other, the protective adhesive layer does not need to be disposed on light receiving surfaces of all the solar cells. While protection on the light receiving surface of the solar cell is ensured, a total amount of adhesive used is reduced, thereby reducing related costs. Certainly, in another embodiment, protective adhesive layers 300 may be respectively disposed on both light receiving surfaces of two solar cells 100 whose light receiving surfaces are in contact with each other. This is not limited in the embodiments of the present application.

In an embodiment, referring to FIG. 8, electrodes 110 of one solar cell 100 in each of the plurality of groups of solar cells W are arranged in an intersecting manner with electrodes 110 of another solar cell 100.

In the embodiments of the present application, in a same group, electrodes 110 of one solar cell 100 are arranged in an intersecting manner with electrodes 110 of another solar cell 100. This means that in a relative positional relationship formed by respective electrodes of the two solar cells 100, there is a state in which the electrodes 110 of one solar cell 100 and the electrodes 110 of the other solar cell 100 are not parallel. As shown in FIG. 8, FIG. 8 shows that the electrodes 110 of one solar cell 100 are perpendicular to the electrodes 110 of the other solar cell 100. By arranging the electrodes in the intersecting manner, support is formed by intersection of the electrodes, to avoid a case in which electrodes of one solar cell are in direct contact with a surface of another solar cell provided with electrodes, in other words, this resolves a problem of surface scratch caused by direct contact between electrodes of one solar cell and a surface of another solar cell provided with electrodes, thereby improving an effect of protecting the back surface of the solar cell.

It should be noted that, the specific features, structures, materials, or characteristics described in the foregoing specification may be combined in a proper manner in any one or more of the embodiments or examples.

In the descriptions of this specification, descriptions such as reference terms "an embodiment", "some embodiments", "schematic embodiment", "example", "specific example", or "some examples" mean that a specific feature, structure, material, or characteristic described with reference to the embodiment or example is included in the present application or at least one embodiment or example of the present application. In this specification, the schematic representations of the foregoing terms do not necessarily represent the same embodiment or example.

Although the embodiments of the present application have been shown and described, a person of ordinary skill in the art may understand that: various changes, modifications, replacements, and variations may be made to the embodiments without departing from the principles and spirit of the present disclosure, and the scope of the present application is defined by the appended claims and equivalents thereof.

**Claims**

1.  A solar cell (100), comprising: a solar cell body (100a), an isolation member (120) being disposed on at least one surface of the solar cell body (100a).

2.  The solar cell (100) according to claim 1, wherein the isolation member (120) comprises a plurality of isolation bumps (230) arranged at intervals, a refractive index of the isolation bumps (230) being less than a refractive index of the solar cell body (100a).

3.  The solar cell (100) according to claim 1, wherein the solar cell body (100a) has a light receiving surface (101) and a back surface (102) opposite to the light receiving surface (101), the plurality of isolation bumps (230) being disposed on the light receiving surface (101).

4.  The solar cell (100) according to claim 2, wherein a ratio of the refractive index of the plurality of isolation bumps (230) to a refractive index of the solar cell body (100a) ranges from 0.6 to 1.15;

    and/or the refractive index of the plurality of isolation bumps (230) ranges from 1.4 to 1.9;
    and/or the refractive index of the solar cell body (100a) ranges from 1.6 to 2.2;
    and/or a light transmittance of the isolation bumps (230) is greater than or equal to 80%.

5.  The solar cell (100) according to any one of claims 2 to 4, wherein a surface of the solar cell body (100a) provided with the plurality of isolation bumps (230) is a first surface, a height of the plurality of isolation bumps (230) along a direction perpendicular to the first surface is H5;

    a cross section perpendicular to a direction in which the plurality of isolation bumps (230) are arranged is a second cross section, a size of the plurality of isolation bumps (230) at an interface of the first surface and the second cross section is L1, H5/L1 is greater than or equal to 0.001;

and/or the size L1 of the plurality of isolation bumps (230) at the interface of the first surface and the second cross section ranges from 0.05 mm to 2 mm.

6. The solar cell (100) according to claim 2 or 3, wherein a plurality of pyramid structures (420) are disposed on a surface of the solar cell body (100a) on which the plurality of isolation bumps (230) are provided, the plurality of isolation bumps (230) cover at least two of the plurality of pyramid structures (420);

and/or the plurality of isolation bumps (230) are arranged in an array;
and/or a material of the plurality of isolation bumps (230) is a UV adhesive;
and/or a Mohs hardness of the plurality of isolation bumps (230) ranges from 2 to 7.

7. The solar cell (100) according to claim 1, wherein a respective isolation member (120) of the plurality of isolation members (120) comprises a recess (7121) recessing into the respective isolation member (120) from a surface of the respective isolation member (120) facing away from the solar cell body (100a);
and/or

a coverage ratio of the plurality of isolation members (120) on the surface of the solar cell (100) is S81, satisfying: $0.5\% \leq S81 \leq 10\%$;
and/or
a height of the plurality of isolation members (120) in a thickness direction of the solar cell (100) is h, satisfying $2 \mu m \leq h \leq 80 \mu m$.

8. The solar cell (100) according to claim 1, wherein

the plurality of isolation members (120) comprise a first protective structure (510) and a second protective structure (530); and
at least one surface of the solar cell body (100a) comprises a middle region (110a) and an edge region (110b) surrounding the middle region (110a);
the edge region (110b) is provided with the first protective structure (510), the middle region (110a) is provided with the second protective structure (530), and the first protective structure (510) is arranged surrounding the second protective structure (530); and
a coverage ratio of the first protective structure (510) on the edge region (110b) is greater than a coverage ratio of the second protective structure (530) on the middle region (110a).

9. The solar cell (100) according to claim 8, wherein the solar cell body (100a) has four sides, a distance from a boundary of the edge region (110b) close to the middle region (110a) to a corresponding side is D, satisfying: $2 cm \leq D \leq 5 cm$;

and/or along a thickness direction of the solar cell body (100a), a height of the first protective structure (510) is equal to a height of the second protective structure (530);
and/or the height of the first protective structure (510) is H3, satisfying: $2 \mu m \leq H3 \leq 80 \mu m$;
and/or the height of the second protective structure (530) is H4, satisfying: $2 \mu m \leq H4 \leq 80 \mu m$;
and/or the solar cell body (100a) has a light receiving surface (101) and a back surface (102), the first protective structure (510) and the second protective structure (530) are disposed on the light receiving surface (101), the back surface (102) is provided with electrodes (110) arranged at intervals.

10. The solar cell (100) according to claim 1, wherein the isolation member (120) comprises an isolation film (540) arranged on the light receiving surface (101) of the solar cell body (100a), the isolation film (540) is provided with a hollow structure (520).

11. The solar cell (100) according to claim 1, wherein:
the solar cell body (100a) has a light receiving surface (101) and a back surface (102), the back surface (102) is provided with electrodes (110), and the light receiving surface (101) is provided with the plurality of isolation members (120) arranged at intervals, an extension direction of at least a portion of the plurality of isolation members (120) is intersected with an extension direction of the electrodes (110).

12. The solar cell (100) according to claim 1, wherein

the solar cell body (100a) has a first surface and a second surface opposite to the first surface;

the solar cell (100) further comprises a plurality of fingers (63) disposed on the first surface of the solar cell body (100a); and

a plurality of isolation members (120) are disposed on at least one of the first surface and/or the second surface of the solar cell body (100a), an extension direction of the plurality of isolation members (120) is intersected with an extension direction of the plurality of fingers (63);

the isolation members (120) comprise a plurality of isolation bumps (621) arranged along the extension direction of the isolation members (120); and

a distance between two adjacent isolation bumps (621) in a same isolation member (120) in the extension direction of the plurality of isolation members (120) is greater than a distance between two adjacent fingers (63).

13. The solar cell (100) according to claim 1, wherein:

a plurality of isolation members (120) arranged at intervals are disposed on at least one surface of the solar cell body (100a), the plurality of isolation members (120) comprising a central portion (712) and a peripheral portion (711) disposed around the central portion (712); and

a surface of the central portion (712) away from the solar cell body (100a) comprises a recess (7121), and in a direction perpendicular to the solar cell body (100a), a minimum height of the central portion (712) is H71, and a maximum height of the plurality of isolation members (120) is H70, satisfying: $0 < H71 \leq \frac{2}{3}H70$.

14. The solar cell (100) according to claim 13, wherein the plurality of isolation members (120) further comprise a cover layer (7124), the cover layer (7124) partially or completely covers the recess (7121).

15. The solar cell (100) according to claim 13, wherein at least one cavity (7113) is formed inside the peripheral portion (711).

16. The solar cell (100) according to claim 1, wherein the solar cell body (100a) comprises a light receiving surface (101) and a back surface (102) opposite to the light receiving surface (101), the light receiving surface (101) comprising a fifth region (813) and a plurality of sixth regions (814);

a plurality of isolation members (120) are disposed on the light receiving surface (101) of the solar cell body (100a), a density of a part of the plurality of isolation members (120) in the fifth region (813) is greater than a density of a part of the plurality of isolation members (120) in the sixth region (814); and

the solar cell (100) further comprises a plurality of fingers (63) disposed on the back surface (102) of the solar cell body (100a), the plurality of sixth regions (814) are positioned along an extension direction of the plurality of fingers (63), an extension direction of the plurality of sixth regions (814) is perpendicular to the plurality of fingers (63).

17. The solar cell (100) according to claim 16, wherein:

no isolation member (120) is provided in the plurality of sixth regions (814);
or

the plurality of sixth regions (814) comprise a first sub-region (8141) and a second sub-region (8142) arranged along a direction perpendicular to the plurality of fingers (63), the first sub-region (8141) is provided with the plurality of isolation members (120), and no isolation member (120) is provided in the second sub-region (8142);
or

the fifth region (813) comprises a plurality of third sub-regions (8131), the third sub-regions (8131) and the sixth regions (814) are alternately arranged along the extension direction of the plurality of fingers (63).

18. The solar cell (100) according to claim 1, wherein the solar cell body (100a) comprises a first surface and a second surface opposite to the first surface; and

the isolation member (120) comprises a plurality of isolation bumps (621) disposed on at least one of the first surface and the second surface of the solar cell body (100a), the plurality of isolation bumps (621) are arranged in a plurality of rows along a fourth direction (X9), each of the plurality of rows of the isolation bumps (621) comprise a plurality of isolation bumps (621) arranged along a fifth direction (Y9);

wherein *l* is a larger one of a distance between two adjacent isolation bumps (621) along the fourth direction (X9) or a distance between two adjacent isolation bumps (621) along the fifth direction (Y9), h is a height of the plurality of isolation bumps (621), n is rounding of a ratio of a long side to a short side of the solar cell (100), and $l$, h, and n satisfy the following relationship:

$$0 < l < \sqrt[4]{15.3 * 10^5 mm^3 * hn}$$

.

19. The solar cell (100) according to claim 18, wherein a maximum size of a projection of a respective isolation bump (621) of the plurality of isolation bumps (621) on the solar cell body (100a) is d, where $d < l$.

20. A photovoltaic module, comprising the solar cell (100) according to any one of claims 1 to 19.

21. The photovoltaic module according to claim 20, wherein the photovoltaic module further comprises a cover (51), a back sheet (52), and a packaging adhesive film (730);

the solar cell (100) is packaged between the cover (51) and the back sheet (52) by the packaging adhesive film (730); and
a peeling strength between the isolation member (120) and the solar cell (100) is greater than a peeling strength between the isolation member (120) and the packaging adhesive film (730).

22. A solar cell stacked structure, comprising a plurality of solar cells (100) that are sequentially stacked, each of the plurality of solar cells (100) being the solar cell (100) according to any one of claims 1 to 19, each of the plurality of solar cells (100) comprising electrodes (110), the electrodes (110) being disposed on a back surface (102) of the solar cell body (100a).

23. The solar cell stacked structure according to claim 22, wherein at least a part of the solar cell stacked structure comprises a plurality of groups of solar cells (100), each of the plurality of groups of solar cells (100) comprises two solar cells (100) whose back surfaces (102) are in contact with each other; and
for two adjacent solar cells (100) whose light receiving surfaces (101) are in contact with each other in the solar cell stacked structure, a protective adhesive layer (300) is provided on the light receiving surface (101) of at least one of the solar cells (100), the protective adhesive layer (300) being used as the isolation member (120).

FIG. 1

FIG. 2

| Printing grid line | Sintering furnace | Isolation adhesive film printing | Optical injection/ Curing oven | AOI test | Tester | Sorting and stacking |

FIG. 3a

| Printing grid line | Sintering furnace | Optical injection/ Curing oven | Isolation adhesive film printing | AOI test | Tester | Sorting and stacking |

FIG. 3b

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

FIG. 19

FIG. 20

FIG. 21

FIG. 22

FIG. 23

FIG. 24

FIG. 25

## INTERNATIONAL SEARCH REPORT

| International application No. |
|---|
| **PCT/CN2025/083383** |

| **A.** | **CLASSIFICATION OF SUBJECT MATTER** |
|---|---|

H10F 19/00(2025.01)i

According to International Patent Classification (IPC) or to both national classification and IPC

| **B.** | **FIELDS SEARCHED** |
|---|---|

Minimum documentation searched (classification system followed by classification symbols)

IPC: H10F

Documentation searched other than minimum documentation to the extent that such documents are included in the fields searched

Electronic data base consulted during the international search (name of data base and, where practicable, search terms used)

CNABS; CNTXT; CNKI; VEN; ENTXT; IEEE: 太阳能电池, 隔离, 折射率, 凸起, solar battery, isolat+, bump, refractive index

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| PX | CN 118039714 A (LONGI GREEN ENERGY TECHNOLOGY CO., LTD.) 14 May 2024 (2024-05-14) description, paragraphs 40-127, and figures 1-7 | 1-3, 6, 20 |
| PX | CN 222322093 U (LONGI GREEN ENERGY TECHNOLOGY CO., LTD.) 07 January 2025 (2025-01-07) description, paragraphs 33-88, and figures 1-9 | 1, 3, 10, 20 |
| PX | CN 222621518 U (LONGI GREEN ENERGY TECHNOLOGY CO., LTD.) 14 March 2025 (2025-03-14) description, paragraphs 50-142, and figures 1-16 | 1, 3, 11, 20 |
| X | CN 208111457 U (HUAQIAO UNIVERSITY) 16 November 2018 (2018-11-16) description, paragraphs 32-55, and figures 1-3 | 1-5, 7-12, 20-23 |
| X | CN 208970522 U (ZHEJIANG JINKO SOLAR CO., LTD. et al.) 11 June 2019 (2019-06-11) description, paragraphs 20-51, and figures 1-2 | 1-5, 7-12, 20-23 |
| A | CN 115663046 A (ZHEJIANG AIKO SOLAR ENERGY TECHNOLOGY CO., LTD. et al.) 31 January 2023 (2023-01-31) entire document | 1-23 |

| ☐ Further documents are listed in the continuation of Box C. | ☑ See patent family annex. |
|---|---|

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **10 June 2025** | **16 June 2025** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

| International application No. |
| --- |
| **PCT/CN2025/083383** |

| Patent document cited in search report | | | Publication date (day/month/year) | Patent family member(s) | Publication date (day/month/year) |
| --- | --- | --- | --- | --- | --- |
| CN | 118039714 | A | 14 May 2024 | None | |
| CN | 222322093 | U | 07 January 2025 | None | |
| CN | 222621518 | U | 14 March 2025 | None | |
| CN | 208111457 | U | 16 November 2018 | None | |
| CN | 208970522 | U | 11 June 2019 | None | |
| CN | 115663046 | A | 31 January 2023 | None | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202410383010
- CN 202420645705
- CN 202420644308
- CN 202420645462
- CN 202420644202
- CN 202421203803
- CN 202510198949
- CN 202520201131X
- CN 202520208673X
- CN 202510215009
- CN 202510221271